(19) Europäisches Patentamt
European Patent Office
Office européen des brevets

(11) EP 3 122 158 A1

(12) **EUROPEAN PATENT APPLICATION**

(43) Date of publication:
**25.01.2017 Bulletin 2017/04**

(21) Application number: **16172135.2**

(22) Date of filing: **31.05.2016**

(51) Int Cl.:
***H05B 33/12*** *(2006.01)* ***H01L 51/00*** *(2006.01)*
***H01L 51/50*** *(2006.01)* ***H01L 27/28*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **02.06.2015 JP 2015112557**

(71) Applicant: **Konica Minolta, Inc.**
**Tokyo 100-7015 (JP)**

(72) Inventors:
- **Osawa, Kou**
**Tokyo, 100-7015 (JP)**
- **Sekine, Koujirou**
**Tokyo, 100-7015 (JP)**

(74) Representative: **Hoffmann Eitle**
**Patent- und Rechtsanwälte PartmbB**
**Arabellastraße 30**
**81925 München (DE)**

(54) **ELECTROLUMINESCENT DEVICE**

(57) An electroluminescent device in which two or more light-emitting units (110A, 110B, 110C) which emit light identical in color are vertically stacked is configured such that a first relative maximal angle or a highest intensity angle viewed in a front direction of angular dependency of emission intensity in light emission from each light-emitting unit alone (110A, 110B, 110C) is different for each light-emitting unit (110A, 110B, 110C), and D (θ) ≥ D (0) cosθ ($0 \leq \theta \leq \theta_D \leq 60$ degrees) ... Expression (1) is satisfied, where D (θ) represents angular dependency of emission intensity and $\theta_D$ represents a specific angle in simultaneous light emission from all light-emitting units (110A, 110B, 110C).

FIG.5

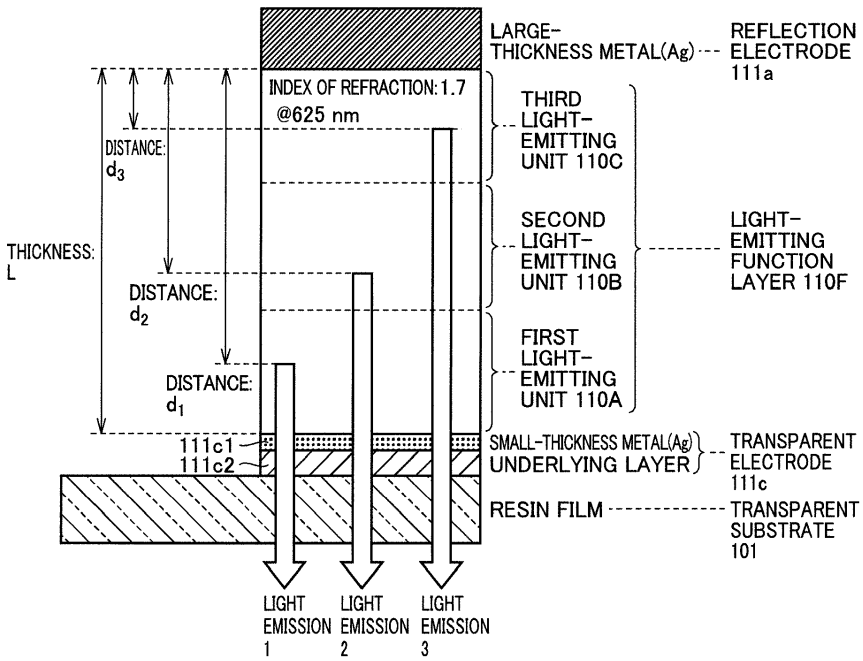


EP 3 122 158 A1

## Description

This application is based on Japanese Patent Application No. 2015-112557 filed with the Japan Patent Office on June 2, 2015, the entire content of which is hereby incorporated by reference.

## BACKGROUND OF THE INVENTION

### Field of the Invention

The present embodiment relates to an electroluminescent device.

### Description of the Related Art

An electroluminescent device high in luminous efficiency which includes an electroluminescent element such as a light-emitting diode (LED) or organic EL has recently attracted attention. The electroluminescent device is formed from an emissive layer (a light-emitting layer) lying between a planar cathode and a planar anode, and generally in many cases, it is formed from a transparent electrode as an anode and a metal reflection electrode as a cathode. Applications of the electroluminescent device include illumination required to ensure a luminance in a range of specific angles in a specific color, such as a downlight for decorative lighting, a colored spotlight in a theater, a colored flash light for signaling, a traffic light, and colored headlight, backup light, and brake light of vehicles.

Generally in an electroluminescent device including an electroluminescent element, an angular distribution of light intensity (light distribution) exhibits a Lambertian light distribution expressed with $\cos\theta$, and a light source which emits intense light in a range of specific angles has not been realized.

A conventional technique discloses a construction for enhancing a front luminance for a display or a construction for enhancing efficiency of a white color with multiple units.

## SUMMARY OF THE INVENTION

Japanese Laid-Open Patent Publication No. 2010-287484 discloses an organic electroluminescent device capable of achieving enhanced efficiency in extraction of light in each color by providing light-emitting layers different in color from one another in each light-emitting unit. A construction for achieving light distribution having desired characteristics at the time when emission from light-emitting units in the same color is combined, however, is unclear.

An organic electroluminescent device disclosed in Japanese Laid-Open Patent Publication No. 2014-225415 realizes a white device with three units. Similarly to the organic light-emitting device disclosed in Japanese Laid-Open Patent Publication No. 2010-287484, however, a construction for achieving light distribution having desired characteristics at the time when emission from light-emitting units in the same color is combined is unclear.

The present embodiment was made in view of such problems, and an object is to provide a monochrome electroluminescent device for ensuring light intensity in a certain range of angles from the front.

An electroluminescent device reflecting one aspect of the present invention is an electroluminescent device in which two or more light-emitting units which emit light identical in color are stacked, and the electroluminescent device is configured such that a first relative maximal angle or an angle at which intensity is highest (a highest intensity angle) viewed in a front direction of angular dependency of emission intensity in light emission from each light-emitting unit alone is different for each light-emitting unit, and $D(\theta) \geq D(0)\cos\theta$ ($0 \leq \theta \leq \theta_D \leq 60$ degrees) ... Expression (1) is satisfied, where $D(\theta)$ represents angular dependency of emission intensity and $\theta_D$ represents a specific angle in simultaneous light emission from all the light-emitting units.

In another form, $\theta_D$ is set to 30 degrees.

In another form, a condition of $\theta 1 > \theta 2 > \theta 3$ is satisfied, with the number of the light-emitting units being set to 3 and $\theta 1$, $\theta 2$, and $\theta 3$ representing highest intensity angles when the light-emitting units emit light individually from a side where light emission is visually recognized, respectively.

In another form, a condition of $\theta 1 < \theta 2 < \theta 3$ is satisfied, with the number of the light-emitting units being set to 3 and $\theta 1$, $\theta 2$, and $\theta 3$ representing highest intensity angles when the light-emitting units emit light individually from a side where light emission is visually recognized, respectively.

In another form, the number of the light-emitting units is set to four or more.

According to the electroluminescent device, a monochrome electroluminescent device for ensuring light intensity in a certain range of angles from the front can be provided.

The foregoing and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a cross-sectional view schematically showing an electroluminescent device in a first embodiment.

Fig. 2 is a cross-sectional view showing a general construction of a surface-emitting panel in the first embodiment.

Fig. 3 is a cross-sectional view showing a basic construction of a light-emitting region of the surface-emitting panel in the first embodiment.

Fig. 4 is a cross-sectional view schematically showing a construction of a surface-emitting panel of a multiple-unit type in the first embodiment.

Fig. 5 is a schematic cross-sectional view with the surface-emitting panel shown in Fig. 4 being replaced with an optically equivalent model.

Fig. 6 is a diagram showing a result of studies about at which angle a relative maximum of intensity appears when a thickness of a light-emitting function layer and a distance from a reflection electrode are varied in the construction shown in Fig. 5.

Fig. 7 is a schematic cross-sectional view showing a condition (a condition (a)) under which interference between light returning from the reflection electrode to an emission point and light at the emission point is reinforced.

Fig. 8 is a schematic cross-sectional view showing a condition (a condition (b)) under which interference between light returning to an emission point as being reflected by a reflection electrode and a transparent electrode and light at the emission point is reinforced.

Fig. 9 is a diagram showing results of studies about a condition under which such interference that phase variation as a whole is reinforced in accordance with the Fresnel reflection theory in the construction shown in Fig. 5, with an angle in air being set to 0 degree and the condition (a) shown in Fig. 7 being set.

Fig. 10 is a diagram showing results of studies about a condition under which such interference that phase variation as a whole is reinforced in accordance with the Fresnel reflection theory in the construction shown in Fig. 5, with an angle in air being set to 0 degree and the condition (b) shown in Fig. 8 being set.

Fig. 11 is a diagram showing results of studies about a condition under which such interference that phase variation as a whole is reinforced in accordance with the Fresnel reflection theory in the construction shown in Fig. 5, with an angle in air being set to 25 degrees and the condition (a) shown in Fig. 7 being set.

Fig. 12 is a diagram showing results of studies about a condition under which such interference that phase variation as a whole is reinforced in accordance with the Fresnel reflection theory in the construction shown in Fig. 5, with an angle in air being set to 25 degrees and the condition (b) shown in Fig. 8 being set.

Fig. 13 is a diagram in which the conditions in Figs. 9 and 10 and Fig. 6 are drawn as being superimposed on each other.

Fig. 14 is a diagram in which the conditions in Figs. 11 and 12 and Fig. 6 are drawn as being superimposed on each other.

Fig. 15 is a flowchart specifically illustrating a step of designing a construction satisfying conditions in the first embodiment.

Fig. 16 is a diagram showing a design example of a result of the flow shown in Fig. 15 in a case of a design with front intensity being prioritized.

Fig. 17 is a diagram showing a result of calculation of angular dependency D ($\theta$) of emission intensity when the light-emitting units shown in Fig. 16 emit light one by one.

Fig. 18 is a diagram showing a result of calculation of angular dependency D ($\theta$) of emission intensity when all the light-emitting units shown in Fig. 16 simultaneously emit light.

Fig. 19 is a diagram showing a design example of a result of the flow shown in Fig. 15 in a case of a design with oblique intensity being prioritized.

Fig. 20 is a diagram showing a result of calculation of angular dependency D ($\theta$) of emission intensity when the light-emitting units shown in Fig. 19 emit light one by one.

Fig. 21 is a diagram showing a result of calculation of angular dependency D ($\theta$) of emission intensity when all the light-emitting units shown in Fig. 19 simultaneously emit light.

Fig. 22 is a diagram showing a design example the same as the design example shown in Fig. 16.

Fig. 23 is a diagram showing a design example the same as the design example shown in Fig. 19.

Fig. 24 is a diagram showing a design example when the number of light-emitting units is set to four.

Fig. 25 is a diagram showing a design example of the surface-emitting panel shown in Fig. 5 in a second embodiment.

Fig. 26 is a diagram showing a result of calculation of angular dependency D ($\theta$) of emission intensity when the light-emitting units emit light one by one in the design example in Fig. 25.

Fig. 27 is a diagram showing a result of calculation of angular dependency D ($\theta$) of emission intensity when all the light-emitting units simultaneously emit light in the design example in Fig. 25.

Fig. 28 is a schematic cross-sectional view with the surface-emitting panel including a dual-unit device in the second embodiment being replaced with an optically equivalent model.

Fig. 29 is a diagram showing a result of a design for realizing the surface-emitting panel including the dual-unit device in the second embodiment.

Fig. 30 is a diagram showing a result of calculation of angular dependency D (θ) of emission intensity when the light-emitting units emit light one by one in the surface-emitting panel including the dual-unit device in the second embodiment.

Fig. 31 is a diagram showing a result of calculation of angular dependency D (θ) of emission intensity when all the light-emitting units simultaneously emit light in the surface-emitting panel including the dual-unit device in the second embodiment.

Fig. 32 is a diagram showing a result of a design for realizing the surface-emitting panel including the dual-unit device in another form in the second embodiment.

Fig. 33 is a diagram showing a result of calculation of angular dependency D (θ) of emission intensity when the light-emitting units emit light one by one in the surface-emitting panel including the dual-unit device in another form in the second embodiment.

Fig. 34 is a diagram showing a result of calculation of angular dependency D (θ) of emission intensity when all the light-emitting units simultaneously emit light in the surface-emitting panel including the dual-unit device in another form in the second embodiment.

Fig. 35 is a diagram showing a cross-sectional structure of an electroluminescent device of a top emission type in a third embodiment.

Fig. 36 is a schematic cross-sectional view of an electroluminescent device of a transparent emission type in the third embodiment.

Fig. 37 is a schematic diagram showing angular dependency of a luminance of light radiated from a transparent member toward an observer when a light guide member and a scattering member of an electroluminescent device are absent.

Fig. 38 is a schematic diagram showing dependency on an angle to a surface normal of a light-emitting portion, of intensity in a transparent member of light emitted in a light-emitting region of an electroluminescent device.

DESCRIPTION OF THE PREFERRED EMBODIMENTS

An electroluminescent device in each embodiment based on the present embodiment will be described hereinafter with reference to the drawings. When the number or an amount is mentioned in an embodiment described below, the scope of the embodiment is not necessarily limited to the number or the amount unless otherwise specified. The same or corresponding elements have the same reference numeral allotted and redundant description may not be repeated. Combination of features in each embodiment as appropriate is originally intended.

(First Embodiment)

A general construction of an electroluminescent device 1 in the present embodiment will be described with reference to Fig. 1. Fig. 1 is a cross-sectional view schematically showing electroluminescent device 1 in the present embodiment. Electroluminescent device 1 has such a structure that a transparent electrode 111c, a first light-emitting unit 110A, a second light-emitting unit 110B, a third light-emitting unit 110C, and a reflection electrode 111a are successively stacked on a transparent substrate 101. The light-emitting units are configured to be identical in emission wavelength.

The electroluminescent device is configured such that a first relative maximal angle or a highest intensity angle when viewed in a front direction of angular dependency of emission intensity in light emission from a light-emitting unit alone is different, and an expression (1) below is satisfied, where D (θ) represents angular dependency (light distribution characteristics) of emission intensity and $\theta_D$ represents a specific angle in simultaneous light emission from all light-emitting units. θ represents an angle from a direction of normal (a front direction) to a light-emitting unit. With such a construction, a monochrome surface-emitting light source for ensuring light intensity within a certain angle from the front can be realized.

$$D(\theta) \geq D(0)\cos\theta \ (0 \leq \theta \leq \theta_D \leq 60 \text{ degrees}) \quad \text{... Expression (1)}$$

Being identical in emission wavelength means that energy from light-emitting units is dominantly superimposed when viewed from a side of visual recognition. For example, a peak wavelength should only be accommodated in a full width at half maximum of a light-emitting unit from a spectrum peak of another light-emitting unit. Here, $\lambda p$ represents a centroidal wavelength of energy while all light-emitting units emit light, and is called an emission wavelength of an electroluminescent device.

Each light-emitting unit in Fig. 1 is called as follows. First light-emitting unit 110A, second light-emitting unit 110B, and third light-emitting unit 110C from a side of transparent substrate 101 are called a light-emitting unit 1, a light-emitting unit 2, and a light-emitting unit 3, respectively. Angular distributions of energy of light while light-emitting units individually emit light are denoted as D1 ($\theta$), D2 ($\theta$), and D3 ($\theta$) for light-emitting unit 1, light-emitting unit 2, and light-emitting unit 3, respectively. Here, light-emitting unit 1, light-emitting unit 2, and light-emitting unit 3 are configured to be different in intensity peak from one another. By doing so, when all light-emitting units emit light, a monochrome surface-emitting light source for ensuring light intensity within a certain angle from the front can be realized.

In Fig. 1, preferably, a condition of $\theta D$ = 30 degrees is set. It has generally been regarded that a viewing angle at which human information capacity is high is $\pm 30$ degrees, and by ensuring light intensity within a range of $\pm 30$ degrees, the same emission intensity can be ensured in the front and at oblique limits to which visual recognition by a human is possible.

An expression (2) below is desirably satisfied, with $\theta 1$, $\theta 2$, and $\theta 3$ represent highest intensity angles while the light-emitting units individually emit light from the side where light emission is visually recognized.

$$\theta_1 > \theta_2 > \theta_3 \quad \text{... Expression (2)}$$

Light distribution characteristics of electroluminescent device 1 having transparent substrate 101 and reflection electrode 111 a are such that an oblique component tends to increase due to an influence by interference as an emission point is distant from reflection electrode 111a. With such a construction, in production of light-emitting units by stacking, a construction facilitating production can be realized.

In particular in carrying out the present embodiment, control of a shape of light distribution is facilitated with a greater number of units. Therefore, for example, the number of units is not limited to three and four or more units are desirable. The number of units may be set to two.

An element such as a desirable member in implementing the electroluminescent device in the present embodiment will be described below.

[1.1 Transparent Member]

A material desirable for a transparent member used for carrying out the present embodiment will be described. In order to realize uniform and highly efficient surface emission, a transmittance of a transparent member is desirably higher. Specifically, a material of which total luminous transmittance in a range of wavelengths of visible light measured with a method in conformity with JIS K 7361-1: 1997 (plastics-determination of the total luminous transmittance of transparent materials) is 80% or higher is preferably used for a transparent member. A highly flexible material is preferably used for a transparent member.

Examples of a transparent member suitably include a resin substrate and a resin film. From a point of view of productivity as well as such performance as light weight and flexibility, a transparent resin film is preferably used. The transparent resin film refers to a resin film of which total luminous transmittance in a range of wavelengths of visible light measured with a method in conformity with JIS K 7361-1: 1997 (plastics-determination of the total luminous transmittance of transparent materials) is 50% or higher.

A preferably used transparent resin film is not particularly restricted, and a material, a shape, a structure, and a thickness thereof can be selected as appropriate from among those which are known. Such a transparent resin film can include, for example, a resin film based on polyester such as polyethylene terephthalate (PET), polyethylene naphthalate, and modified polyester, a polyethylene (PE) resin film, a polypropylene (PP) resin film, a polystyrene resin film, a film of polyolefin resins such as a cyclic olefin based resin, a resin film based on vinyl such as polyvinyl chloride and polyvinylidene chloride, a polyether ether ketone (PEEK) resin film, a polysulfone (PSF) resin film, a polyether sulfone (PES) resin film, a polycarbonate (PC) resin film, a polyamide resin film, a polyimide resin film, an acrylic resin film, and a triacetyl cellulose (TAC) resin film.

The above-mentioned resin film of which total luminous transmittance is 80% or higher would more preferably be employed for a transparent member according to the present embodiment. From a point of view of transparency, resistance to heat, handleability, strength, and cost among others, a biaxially oriented polyethylene terephthalate film, a biaxially oriented polyethylene naphthalate film, a polyether sulfone film, or a polycarbonate film is preferred for such a transparent member, and a biaxially oriented polyethylene terephthalate film or a biaxially oriented polyethylene naphthalate film is more preferred.

A coating of an inorganic substance, a coating of an organic substance, or a hybrid coating of an inorganic substance and an organic substance may be formed on a front surface or a rear surface of a base material in a form of a film. A base material having such a coating formed is preferably formed as a barrier film of which water vapor transmission rate measured with a method in conformity with JIS K 7129-1992 (25±0.5°C and relative humidity (90±2)% RH) is not higher than $1\times10^{-3}$ g/($m^2$·24h), and further preferably as a high-barrier film of which oxygen transmission rate measured with a method in conformity with JIS K7126-1987 is not higher than $1\times10^{-3}$ ml/$m^2$·24h·atm and water vapor transmission rate (25±0.5°C and relative humidity (90±2)% RH) is not higher than $1\times10^{-3}$ g/($m^2$·24h).

A material for forming a barrier film on the front surface or the rear surface of the base material in a form of a film for obtaining a high-barrier film should only be a material having a function to suppress entry of a substance which degrades a device, such as moisture or oxygen, and for example, silicon oxide, silicon dioxide, or silicon nitride can be employed. In order to overcome weakness of the barrier film, a stack structure of an inorganic layer and a layer composed of an organic material is more preferred. Though an order of stack of the inorganic layer and the organic layer is not particularly restricted, they are preferably alternately stacked a plurality of times.

The transparent member according to the present embodiment can be subjected to surface treatment or can be provided with an easily adhesive layer in order to secure wettability and adhesiveness. A conventionally known technique can be employed for surface treatment and the easily adhesive layer. For example, examples of surface treatment include such surface activation treatment as corona discharge treatment, flame treatment, ultraviolet treatment, high-frequency treatment, glow discharge treatment, active plasma treatment, and laser treatment. Examples of the easily adhesive layer include polyester, polyamide, polyurethane, a vinyl based copolymer, a butadiene based copolymer, an acrylic copolymer, a vinylidene based copolymer, and an epoxy based copolymer. The easily adhesive layer may be formed from a single layer or two or more layers for improvement in adhesiveness.

[1.2 Surface-Emitting Panel 110]

An organic EL light-emitting panel can be employed for a surface-emitting panel. Figs. 2 and 3 schematically show a construction of a surface-emitting panel (bottom emission) 110. Fig. 2 is a cross-sectional view showing a general construction of surface-emitting panel (bottom emission) 110 and Fig. 3 is a cross-sectional view showing a basic construction of a light-emitting region.

Surface-emitting panel 110 is constructed by providing a light-emitting region 111 on transparent substrate 101 and thereafter providing sealing with a sealing member 120 which prevents entry of moisture which degrades organic EL. Transparent substrate 101 and light-emitting region 111 include the construction of electroluminescent device 1 described above.

A non-light-emitting region 112 extending over a certain region is present around light-emitting region 111 in order to retain sealing capability. Fig. 3 shows a further detailed basic construction of light-emitting region 111 formed on transparent substrate 101. The light-emitting region is constituted of transparent substrate 101/transparent electrode (anode) 111c/a hole injection layer (HIL) 111b5/a hole transfer layer (HTL) 111b4/an emissive layer (EML) 111b3/an electron transfer layer (ETL) 111b2/an electron injection layer (EIL) 111b1/reflection electrode 111a.

In the present embodiment, light-emitting region 111 is not limited to the construction in Fig. 3. Examples of other constructions of the light-emitting region include, for example, a construction constituted of an anode/an emissive layer/an electron transfer layer/a cathode, a construction constituted of an anode/a hole transfer layer/an emissive layer/an electron transfer layer/a cathode, a construction constituted of an anode/a hole transfer layer/an emissive layer/a hole blocking layer/an electron transfer layer/a cathode, a construction constituted of an anode/a hole transfer layer/an emissive layer/a hole blocking layer/an electron transfer layer/a cathode buffer layer/a cathode, and a construction constituted of an anode/an anode buffer layer/a hole transfer layer/an emissive layer/a hole blocking layer/an electron transfer layer/a cathode buffer layer/a cathode.

A flexible resin substrate having flexibility is desirably used for transparent substrate 101 or sealing member 120, and a material for the transparent member described previously is desirably employed. Transparent substrate 101 or sealing member 120 may have plasticity. With plasticity, a state once bent can be held and hence stress during fixing of the transparent substrate or the sealing member in bonding thereof to a curved surface can advantageously be relaxed. Though description has been given here with reference to the bottom-emission example, a top-emission construction in which light is emitted toward sealing may be employed.

Surface-emitting panel 110 includes in its part, non-light-emitting region 112 for providing a sealing region for preventing degradation of light-emitting region 111 and an electrode for power feed. When surface-emitting panel 110 has flexibility, it can advantageously be arranged in conformity with any shape. In particular, when non-light-emitting region 112 is higher in flexibility and smaller in thickness than light-emitting region 111, it is layered in tiling so that a width of non-light-emitting region 112 can advantageously be decreased.

[1.3 Transparent Electrode 111c]

A more specific material for transparent electrode 111c includes a small-thickness metal electrode. Among others, a transparent electrode formed from a nitrogen-containing underlying layer and a small-thickness metal (Ag) as being combined (see Fig. 4) is desirably used in particular as shown in Japanese Patent No. 5266532. The nitrogen-containing underlying layer has a property to allow the small-thickness metal to form a continuous film. Since the small-thickness metal formed as the continuous film is high in Fresnel reflectance at an interface, an effect of interference of light can be enhanced.

A metal here refers to a material of which real part of a complex relative permittivity is negative in an emission wavelength of the surface-emitting panel. A complex relative permittivity $\varepsilon_c$ represents an optical constant associated with interface reflection, and it represents a physical quantity expressed with an index of refraction n and an extinction coefficient $\gamma$ in an expression (3) below.

$$\varepsilon_c = (n^2 - \kappa^2) + 2in\kappa$$
$$\mathbf{P} = (\varepsilon_c - \varepsilon_o)\mathbf{E} \qquad \text{... Expression (3)}$$

P and E represent polarization and electric field, respectively, and $\varepsilon_o$ represents a permittivity in vacuum. It can be seen from the expression (3) that as n is smaller and $\kappa$ is greater, a real part of the complex relative permittivity is smaller. This represents an effect of phase shift from oscillation of electric field, of polarization response due to oscillation of electrons. The negative real part of the complex relative permittivity expressed in the expression (3) means that electric field oscillation and polarization response are reversed, which represents characteristics of the metal. In contrast, when the real part of the complex relative permittivity is positive, a direction of electric field and a direction of polarization response match with each other and polarization response as a dielectric is exhibited. In summary, a medium of which real part of a complex relative permittivity is negative is a metal, and a substance of which real part of the complex relative permittivity is positive is a dielectric.

In general, a lower index of refraction n and a greater extinction coefficient $\kappa$ mean a material of which electrons well oscillate. A material high in electron transferability tends to be low in index of refraction n and great in $\kappa$. In particular, a metal electrode has n around 0.1 whereas it has a large value for $\kappa$ from 2 to 10, and it is also high in rate of change with a wavelength. Therefore, even when a value for n is the same, a value for $\kappa$ is significantly different, and there is a great difference in performance in transfer of electrons in many cases.

In carrying out the present embodiment, a metal which increases a Fresnel reflectance is desirably adopted as a material for the transparent electrode. As a more specific requirement for an index of refraction, a metal low in n and high in $\kappa$ is desirable in order to improve response of electrons. For example, aluminum (Al), silver (Ag), and calcium (Ca) are desirable. In other examples, gold (Au) which is also advantageously less prone to oxidization is possible. Another material is exemplified by copper (Cu), and this material is high in conductivity. Other materials which have good thermal properties or chemical properties, are less prone to oxidization even at a high temperature, and do not chemically react with a material for a substrate include platinum, rhodium, palladium, ruthenium, iridium, and osminium. An alloy containing a plurality of metal materials may be employed. In particular, MgAg or LiAl is often used for a small-thickness transparent metal electrode.

A particularly desirable thickness d of a small-thickness metal is expressed in an expression (4) below with extinction coefficient $\kappa$ and emission wavelength $\lambda$, based on a distance at which attenuation to light intensity 1/e is caused.

$$d \leq \frac{\lambda}{4\pi}\kappa \qquad \text{... Expression (4)}$$

In terms of more specific figures, when an Ag thin film is employed at a wavelength of 475 nm, an expression (5) below is derived, because an extinction constant is set to 2.7. Therefore, a thickness is desirably not greater than 13.9 nm.

$$d \leq \frac{\lambda}{4\pi\kappa} = \frac{475}{4\pi \times 2.7} = 13.9\text{nm} \qquad \text{... Expression (5)}$$

[1.4 As to Specific Angle θD]

As described above, in the present embodiment, an expression (6) below is satisfied (the expression the same as the expression (1)) where D (θ) represents angular dependency of emission intensity and $\theta_D$ represents a specific angle in simultaneous light emission from all light-emitting units.

$$D(\theta) \geq D(0)\cos\theta \ (0 \leq \theta \leq \theta_D \leq 60 \text{ degrees}) \qquad \text{... Expression (6)}$$

How this specific angle θD can be determined will be exemplified. Initially, the angle may be determined under an ordinance. Safety standards for road trucking vehicles (Ordinance of Ministry of Transport No. 67 on July 28, 1946, Revised Ordinance of Ministry of Land, Infrastructure, Transport and Tourism No. 3 on January 22,2015) and an announcement relating thereto show angular characteristics required of a headlight and the like of vehicles. When an electroluminescent device is employed in such a headlight, a front fog lamp, a cornering lamp, a cornering lamp during low-speed driving, a road light, an upper front end light, a marker lamp, a license plate light, a taillight, a rear fog lamp, a parking light, an upper rear end light, a brake light, an auxiliary brake light, a backup light, a direction indicator, an auxiliary direction indicator, a hazard flasher, an emergency brake indicator, and a rear collision warning indicator, at least a specific luminance value should be obtained in a range not greater than specific angle θD.

Then, the specific angle can be defined based on a range of angles in which sensing with the sense of sight of a human can be made. It is important that lighting to be looked at by a human (such as a traffic signal, a signal lamp, and a taillight of a vehicle) has a specific luminance at least in a range of angles in which a human can have a view. In connection with the sense of sight of a human, allegedly, "an effective field of view in which excellent information capacity is obtained is merely approximately 30 degrees in a horizontal direction and approximately 20 degrees in a vertical direction, and a stable field of fixation in which a point of gaze is quickly looked at in a stable manner is approximately from 60 to 90 degrees in a horizontal direction and approximately from 45 to 70 degrees in a vertical direction (http://www.lab.ime.cmc.osaka-u.ac.jp/~kiyo/cr/kiyokawa-2002-03-Hikari-Report/kiyokawa-2002-03-Hikari-Report.pdf). Therefore, when a condition of θD = 30 degrees is set, such information that a traffic signal is turned on can be sent in a range of the effective field of view in which information capacity is excellent.

[1.5 More Specific Example of Present Embodiment]

[1.5.1 Relation Between Detailed Construction of Electroluminescent Device and Peak Angle of Emission Intensity in Air]

An electroluminescent device obtained by carrying out the more specific present embodiment will be described below. Fig. 4 schematically shows a construction of a surface-emitting panel of a multiple-unit type (bottom emission). The surface-emitting panel is constructed by providing light-emitting region 111 on transparent substrate 101 and thereafter providing sealing with the sealing member (see Fig. 2) which prevents entry of moisture which degrades organic EL. Non-light-emitting region 112 extending over a certain region is present around light-emitting region 111 in order to retain sealing capability (see Fig. 2).

In the present embodiment, a surface-emitting panel of a multiple-unit type obtained by stacking a plurality of light-emitting units each including "hole injection layer (HIL) 111b5/hole transfer layer (HTL) 111b4/emissive layer (EML) 111b3/electron transfer layer (ETL) 111b2/electron injection layer 111b1" with a charge generation layer 111b6 being interposed is employed. Though a device including three light-emitting units will be described below, the present embodiment is not limited to three light-emitting units, and for example, two light-emitting units, four light-emitting units, five light-emitting units, or five or more light-emitting units may be provided.

More specifically, the light-emitting region is constituted of transparent substrate 101/transparent electrode (anode) 111c/first light-emitting unit 110A/charge generation layer 111b6/second light-emitting unit 110B/charge generation layer 111b6/third light-emitting unit 110C/reflection electrode 111a.

Each of first light-emitting unit 110A, second light-emitting unit 110B, and third light-emitting unit 110C is constituted of hole injection layer (HIL) 111b5/hole transfer layer (HTL) 111b4/emissive layer (EML) 111b3/electron transfer layer (ETL) 111b2/electron injection layer (EIL) 111b1.

Electron injection layer (EIL) 111b1 is provided between electron transfer layer (ETL) 111b2 and charge generation layer 111b6 in order to improve efficiency in injection of electrons. Therefore, in some cases, electron injection layer (EIL) 111b1 does not have to be provided.

In first light-emitting unit 110A, second light-emitting unit 110B, and third light-emitting unit 110C, emissive layers (EML) 11 lb3 are identical in emission color and emit light in accordance with an injected current. With such a multiple-unit structure, a quantity of light emission per injected current can be increased. Since drive lifetime is longer as the injected current is lower, drive lifetime at the same luminance can be improved.

Here, "being identical in emission color" means that energy from light-emitting units is dominantly superimposed when viewed from the side of visual recognition. For example, a peak wavelength should only be accommodated in a full width at half maximum of a light-emitting unit from a spectrum peak of another light-emitting unit. Furthermore, at an emission centroidal wavelength of one light-emitting unit, spectrum overlap with another light-emitting unit should only be 50% or higher and desirably 80% or higher. By doing so, all light-emitting units emit light substantially identical in color.

Then, color deviation among light-emitting units can be lessened when viewed in a Yxy color space defined by Commission Internationale de l'Eclairage (CIE). Color deviation among light-emitting units is desirably less than 0.1 when viewed in the Yxy color space. Furthermore, a distance on a u'v' coordinate on the CIE 1976 UCS chromaticity diagram defined by CIE as an indicator close to the sense of sight of a human is desirably lower than 0.1.

Such characteristics that light-emitting units are identical in color as above are important, for example, in a taillight of a car or a traffic signal. In particular in applications to cars, the "identical emission color" is realized as colors obtained while all light-emitting units emit light individually are accommodated in a range of chromaticity determined under the ordinance. In this case, the emission color is desirably high in monochromatism, rather than white. In particular, a saturation is desirably 50% or higher when viewed in an HSV color space invented by Alvy Ray Smith in 1978, and an xy distance from a white point at 6500K of a white color is desirably 0.1 or greater when viewed in the Yxy color space defined by Commission Internationale de l'Eclairage (CIE). With a sufficient distance from the white point, color information can thus be conveyed to a viewer when it is visually recognized.

Description of a detailed design is continued with reference to Fig. 4. An example for implementing an electroluminescent device in which all light-emitting units emit light in a single red color will be described here. Namely, a surface-emitting panel satisfying a condition of "D ($\theta$) $\geq$ D (0) cos$\theta$ ($0<\theta\leq\theta_D\leq60$ degrees) where D ($\theta$) represents angular dependency of emission intensity and $\theta_D$ represents a specific angle when all light-emitting units simultaneously emit light," with a condition of $\theta$D = 30 degrees being set, is designed.

Angular dependency of emission intensity is designed with a technique for analyzing an optical multi-layered film. A method described in Chapter 5, Section 1 of a known document (Kotaro Kajikawa et al., "Active Plasmonics," Corona Publishing Co., Ltd., First Edition, First Copy, 2013) was employed as a method of calculation. In addition, a finite difference time domain (FDTD) method or a finite element method which is a known technique for analyzing electromagnetic field can also be employed.

In calculating an emission spectrum of a device in calculation, an inverse operation of an internal emission spectrum of a light-emitting layer was performed with an electroluminescence spectrum (EL spectrum) at the time of injection of a current of a standard device and an emission spectrum at the time of injection of the current was accurately estimated. An emission spectrum of each light-emitting unit obtained through inverse operation from an electroluminescence spectrum of the standard device and efficiency in extraction of light of the standard device had a peak wavelength at a wavelength of 625 mm and a light spectrum of which spectrum full width at half maximum was 70 nm.

Thus, a method of estimating an internal spectrum by using a spectrum at the time of current injection of the standard device is more advantageous in more accurate estimation of an internal spectrum at the time of injection of a current than a method of estimating an internal emission spectrum with a photoluminescence spectrum of a material. A design desirable for carrying out the present embodiment will be described below, with attention being paid to a spectrum peak wavelength of 625 nm.

Fig. 5 shows a schematic cross-sectional view with the surface-emitting panel shown in Fig. 4 being replaced with an optically equivalent model. As shown in Fig. 5, optically, a four-tiered stack structure of "transparent substrate 101/transparent electrode 111c/a light-emitting function layer 110F/reflection electrode 111a" is provided, and an emission point of each light-emitting unit is simplified as being present at any point in an organic material layer. An index of refraction of light-emitting function layer 110F is denoted by a character $n_{EML}$ as an equivalent refractive index of the entire multi-layered film included in light-emitting function layer 110F. Equivalent refractive index $n_{EML}$ is expressed in an expression (7) below, where $\varepsilon$c represents a value obtained by weight averaging complex relative permittivities of materials contained in light-emitting function layer 110F with a thickness of each layer.

$$n_{EML} = \sqrt{\varepsilon_c} \quad \text{... Expression (7)}$$

The present embodiment should be "configured such that a highest intensity angle of angular dependency of emission intensity in light emission from each light-emitting unit alone is different." Here, Fig. 6 shows a result of studies about at which angle a relative maximum of intensity appears when a thickness L of light-emitting function layer 110F and a distance d from reflection electrode 111a are varied in the construction shown in Fig. 5. In Fig. 6, 0, 10, 20, 30, 40, 50, and 60 represent peak angles [deg] of light emission in air, the abscissa represents thickness L of light-emitting function layer 110F, and the ordinate represents distance d from reflection electrode 111a to the emission point. Here, the emission point refers to a position at which a concentration of a dopant is highest in the emissive layer, and may be defined as the center of the emissive layer for the sake of convenience.

In calculation, a large-thickness metal Ag of reflection electrode 111a has a thickness of 100 nm, light-emitting function layer 110F has equivalent refractive index $n_{EML}$ of 1.74, small-thickness metal (Ag) 111c forming transparent electrode 111c has a thickness of 10 nm, an underlying layer 111c2 has an index of refraction of 1.84 and a thickness of 10 nm, and a resin film forming transparent substrate 101 has an index of refraction of 1.50 and a thickness of 250 $\mu$m.

An index of refraction of a metal Ag is set to 1.23+6.06i expressed as a complex number. Since distance d from a reflection electrode is smaller than thickness L of the light-emitting function layer in Fig. 6, there is no contour line in an upper left half of the figure. As shown in Fig. 6, a peak angle of emission intensity is dependent on thickness L of light-emitting function layer 110F and distance d from the reflection electrode.

Figs. 7 and 8 each show a schematic diagram for showing a condition under which interference of light is reinforced. Fig. 7 is a schematic cross-sectional view showing a condition (a condition (a)) under which interference between light returning from reflection electrode 111a to an emission point and light at the emission point is reinforced. Fig. 8 is a schematic cross-sectional view showing a condition (a condition (b)) under which interference between light returning to the emission point as being reflected by reflection electrode 111a and transparent electrode 111c and light at the emission point is reinforced.

Referring to Fig. 7, the condition (the condition (a)) under which phases are reinforced by each other in this case is expressed in an expression (8) below.

$$2\left[\left(n_{EML}\cos\theta_{EML}\right)\frac{2\pi}{\lambda}d\right]+\phi_m\left(\theta_{EML}\right)=2m\pi \quad m=\{0,1,2,\cdots\}$$

$$n_{EML}\sin\theta_{EML}=1.0\sin\theta \Rightarrow \theta_{EML}=\sin^{-1}\left(\frac{\sin\theta}{n_{EML}}\right) \qquad \text{... Expression (8)}$$

Referring to Fig. 8, the condition (the condition (b)) under which phases are reinforced by each other in this case is expressed in an expression (9) below.

$$2\left[\left(n_{EML}\cos\theta_{EML}\right)\frac{2\pi}{\lambda}L\right]+\phi_m\left(\theta_{EML}\right)+\phi_e\left(\theta_{EML}\right)=2l\pi \quad l=\{0,1,2,\cdots\} \qquad \text{... Expression (9)}$$

$\lambda$ represents a wavelength in vacuum, $\theta_{EML}$ represents an angle of light inside light-emitting function layer 110F, and $\theta$ represents an angle of light in air, which are associated under the Snell's law. Phase variation $\phi_m$ due to reflection at an interface between light-emitting function layer 110F and reflection electrode 111a and phase variation $\phi_e$ due to reflection at an interface between light-emitting function layer 110F and transparent electrode 111c when transparent electrode 111c and transparent substrate 101 are viewed from light-emitting function layer 110F are a function of $\theta_{EML}$ which varies depending on an angle.

When an angle in air is set to 25 degrees and the construction is as shown in Fig. 5, a condition of $n_{EML}$ = 1.74 and $\theta_{EML}$ = 14 degrees is satisfied. As can be seen in the expression (8), the condition under which interference between light returning from reflection electrode 111a to the emission point and light at the emission point is reinforced in Fig. 7 is dependent only on distance d from reflection electrode 111a. Similarly, as can be seen in the expression (9), the condition under which interference of light reflected by reflection electrode 111a and transparent electrode 111c and returning to the emission point is reinforced in Fig. 8 is dependent only on thickness L of light-emitting function layer 110F.

Figs. 9 to 12 show results of studies about a condition under which such interference that phase variation as a whole is reinforced in accordance with the Fresnel reflection theory is achieved. Fig. 9 shows a case that an angle in air is set to 0 degree and the condition (a) shown in Fig. 7 is set, Fig. 10 shows a case that an angle in air is set to 0 degree and the condition (b) shown in Fig. 8 is set, Fig. 11 shows a case that an angle in air is set to 25 degrees and the condition (a) shown in Fig. 7 is set, and Fig. 12 shows a case that an angle in air is set to 25 degrees and the condition (b) shown in Fig. 8 is set.

As can be seen in Figs. 9 to 12, in air, the condition under which intensity is high in the front (0 degree) and the condition under which intensity is high in an oblique direction (25 degrees) are different from each other. The present embodiment discloses a desirable construction for ensuring intensity in both of the front and the oblique direction in consideration of this aspect.

Consistency between Fig. 6 and Figs. 9 to 12 will now be checked. Fig. 13 shows a diagram in which the conditions in Figs. 9 and 10 and Fig. 6 are drawn as being superimposed on each other. Fig. 13 shows a region where a peak angle of light intensity in air is at 0 degree in Fig. 6 as being filled with black. The condition in Fig. 9 (the condition (a)) is shown with a lateral dotted line and the condition in Fig. 10 (the condition (b)) is shown with a vertical dotted line. Substantial correspondence with the condition in Fig. 9 and the condition in Fig. 10 can be seen. There is a tolerance on a side where a thickness is small under the condition in Fig. 10. Therefore, even when the condition in Fig. 10 is not strictly satisfied, light can be directed to a direction of 0 degree and there is a tolerance in terms of design in the direction of 0 degree.

Similarly, Fig. 14 shows a diagram in which the conditions in Figs. 11 and 12 and Fig. 6 are drawn as being superimposed on each other. Fig. 14 shows a region where a peak angle of light intensity in air is at 25±5 degrees in Fig. 6 as being filled with black. The condition in Fig. 11 (the condition (a)) is shown with a lateral dotted line and the condition in Fig. 12 (the condition (b)) is shown with a vertical dotted line. Substantial correspondence with the condition in Fig. 11 and the condition in Fig. 12 can be seen. Fig. 14 is smaller in tolerance for the condition (b) than Fig. 13.

When Figs. 6, 13, and 14 are well reviewed, it can be seen that a peak angle of light intensity at the time when distance d from reflection electrode 111a varies tends to vary when distance d from reflection electrode 111a to the emission point is great, in spite of thickness L of light-emitting function layer 110F being constant. Namely, a peak angle of emission intensity in air tends to vary depending on d at a position where distance d from reflection electrode 111a is great. Similarly, a peak angle in air is substantially determined by thickness L of light-emitting function layer 110F and a peak angle of emission intensity in air is less likely to vary depending on d at a position where distance d from reflection electrode 111a is small. The present embodiment was obtained based on a difference in influence on an angular peak of emission intensity in air by distance d from reflection electrode 111a and thickness L of light-emitting function layer 110F.

[1.5.2 Desirable Design Position]

[1.5.2.1 Design with Intensity in Front Being Prioritized]

A desirable first design position will be described with reference to Fig. 6 again. As described in [1.5.1], variation in angle with fluctuation in d is less at a design position smaller in distance d from reflection electrode 111a to the emission point. In consideration of a distance of the first light-emitting unit from the reflection electrode, distance d from reflection electrode 111a fluctuates depending on the number of layers larger than the number of layers in the case of the third light-emitting unit. Therefore, when the first light-emitting unit, the second light-emitting unit, and the third light-emitting unit are compared with one another, the third light-emitting unit is least likely to experience fluctuation in peak angle associated with fluctuation in thickness.

Therefore, when design with priority being placed on intensity in the front is considered, a condition satisfying an expression (10) below is desirable, with θ1, θ2, and θ3 representing highest intensity angles when the light-emitting units emit light individually from the side where light emission is visually recognized, respectively.

$$\theta_1 > \theta_2 > \theta_3 \quad \text{... Expression (10)}$$

With such a design, resistance to fluctuation in thickness, of an intensity component in the front, can be improved. Applications as ensuring intensity in particular from 0 degree to 20 degrees are required to be designed with priority being placed on intensity in the front. More specifically, such applications include a headlight and a taillight of cars and a signaling light.

Referring to Fig. 6 and the expressions (8) and (9), a specific design step satisfying the condition in the expression (10) will be described. Fig. 15 shows a design step. Namely, the design step satisfying the condition in the present embodiment has at least steps from S10 to S70 below.

The number of light-emitting units $n_{unit}$ is determined (S10). Then, an order 1 associated with total thickness L of light-emitting function layer 110F is determined as "1= $n_{unit}$-1" (S20). Then, a peak intensity angle of each light-emitting unit θ = {θ1, θ2, θ3, ..., θ$n_{unit}$} is determined (S30).

Then, total thickness L of light-emitting function layer 110F is determined (S40). Then, distance d from the reflection electrode, of the emission point of the $n_{unit}$th light-emitting unit from the side where light emission is visually recognized is determined (S50). Then, distance d from the reflection electrode, of the emission point of each of the first to the ($n_{unit}$-1)th light-emitting units from the side where light emission is visually recognized, is determined (S60).

Then, total thickness L of light-emitting function layer 110F, a peak angle of emission intensity of each of the first to the $n_{unit}$th light-emitting units from the side where light emission is visually recognized, and an angular distribution of emission intensity with all light-emitting units emitting light are calculated, and total thickness L of the light-emitting function layer and distance d from the reflection electrode, of each of the first to the $n_{unit}$th points of emission from the side where light emission is visually recognized, are finely adjusted (S70).

The step of designing a construction satisfying the condition in the present embodiment will specifically be described below with reference to Fig. 15.

[S10: Step of Determining the Number of Light-Emitting Units $n_{unit}$]

Light-emitting units different in peak angle from one another at an interval of at least 10 degrees, desirably at an interval of 5 degrees, are desirably prepared. For example, when emission intensity between 0 and 30 degrees is to be ensured, a calculation of 30/10=3 is made, and hence a condition of $n_{unit} \geq$ three light-emitting units should only be satisfied. For example, a condition of $n_{unit} = 3$ is set.

[S20: Step of Determining Order 1 Associated with Total Thickness L of Light-Emitting Function Layer 110F as "1= $n_{unit}$-1"]

For example, since the condition of $n_{unit} = 3$ is set in S10, a condition of 1 = $n_{unit}$-1 = 2 is set.

[S30: Step of Determining Peak Intensity Angle of Each Light-Emitting Unit]

Light-emitting units different in peak angle from one another at an interval of at least 10 degrees, more desirably at an interval of 5 degrees or smaller, are desirably prepared. In general, since an angular component in the front is ensured approximately to some extent also when there is a peak angle in an oblique direction, a light-emitting unit having a peak angle in the front direction does not have to be provided.

In general, an expression (11) below is preferably satisfied, with the number of light-emitting units being set to $n_{unit}$ and θ1, θ2, θ3, ..., $\theta n_{unit}$ representing highest intensity angles while the light-emitting units emit light individually from the side where light emission is visually recognized, respectively.

$$\theta_1 > \theta_2 > \ldots > \theta n_{unit} \quad \ldots \text{ Expression (11)}$$

For example, in a design having intensity in the front direction and also ensuring an oblique component, a condition of θ1 = 15 degrees, θ2 = 10 degrees, and θ3 = 5 degrees is set. This satisfies the condition "θ1 > θ2 > θ3, with the number of light-emitting units being set to 3 and θ1, θ2, and θ3 representing highest intensity angles while the light-emitting units emit light individually from the side where light emission is visually recognized, respectively." Though the condition of θ1 = 15 degrees is set, intensity can be ensured approximately in a range of a set angle ± 5 degrees, and hence the present setting corresponds to a design which ensures intensity up to 20 degrees.

[S40: Step of Determining Total Thickness L of Light-Emitting Function Layer]

Total thickness L of the light-emitting function layer is determined as shown below. A condition for reinforcement at a specific angular peak based on the expression (9) is given in an expression (12) below.

$$L = \frac{\lambda}{2n_{EML}\cos\theta_{EML}}\left[l - \frac{\phi_m + \phi_e}{2\pi}\right] \quad l = \{0, 1, 2, \cdots\}$$

$$\theta_{EML} = \sin^{-1}\left(\frac{\sin\theta}{n_{EML}}\right) \quad \ldots\text{. Expression (12)}$$

As can be seen with reference to Fig. 6, unless the order is high to some extent, a peak of an angle different for each light-emitting unit cannot be provided. In order to provide an angular peak different for each light-emitting unit, the order for L should be not less than $n_{unit}$-1. Too high an order leads to too large a thickness and resultant increase in cost for materials. Therefore, the order for L is optimally set to $n_{unit}$-1.

Though the expression (12) represents a strict condition for phase matching, substantial matching is achieved even though a phase is shifted by approximately 10% from an integer multiple of 2π and a peak angle is close to a target. Therefore, a practically more preferable range of L preferably satisfies an expression (13) below.

$$\frac{\lambda}{2n_{EML}\cos\theta_{EML}}\left[l-\frac{\phi_m+\phi_e}{2\pi}-0.1\right]\leq L\leq\frac{\lambda}{2n_{EML}\cos\theta_{EML}}\left[l-\frac{\phi_m+\phi_e}{2\pi}+0.1\right]$$

$$l=n_{stack}-1$$

$$\theta_{EML}=\sin^{-1}\left(\frac{\sin\theta}{n_{EML}}\right)$$

... Expression (13)

As described previously, the $n_{unit}$th light-emitting unit from the side where light emission is visually recognized which is closest to the reflection electrode is less in fluctuation in peak angle associated with fluctuation in thickness. Thus, the order for L is desirably set for the $n_{unit}$th light-emitting unit from the side where light emission is visually recognized.

For example, since a condition of θ3 = 5 degrees is set for the third light-emitting unit, a range of desirable thicknesses is found based on an expression (14) below, with conditions of 1 = 3-1 = 2 and $n_{EML}$ =1.74 being set and conditions of $\theta_{EML}$ = 2.9 degrees, ϕm = -0.83π, and ϕe = -0.63π being set based on the Fresnel reflectance theory in the expression (13). Here, a condition of L = 491 nm is set.

$$\frac{625\text{ nm}}{2\times1.74\times\cos2.9^\circ}\left[(3-1)-\frac{(-0.83-0.63)\pi}{2\pi}-0.1\right]\leq L\leq\frac{625}{2\times1.74\times\cos2.9^\circ}\left[(3-1)-\frac{(-0.83-0.63)\pi}{2\pi}-0.1\right]$$

$$\Leftrightarrow 472\text{ nm}\leq L\leq 509\text{ nm}$$

... Expression (14)

[S50: Step of Determining Distance d from Reflection Electrode, of Emission Point of $n_{unit}$th Light-Emitting Unit from Side Where Light Emission Is Visually Recognized]

As described previously, the $n_{unit}$th light-emitting unit from the side where light emission is visually recognized is less in fluctuation in peak angle associated with fluctuation in thickness, and a position of the emission point is preferentially determined. With reference to the expression (8) here, the condition for position d of the emission point at which reinforcement at a specific angular peak is achieved is rewritten as in an expression (15) below.

$$d=\frac{\lambda}{2n_{EML}\cos\theta_{EML}}\left[m-\frac{\phi_m}{2\pi}\right]\quad m=\{0,1,2,\cdots\}$$

$$\theta_{EML}=\sin^{-1}\left(\frac{\sin\theta}{n_{EML}}\right)$$

... Expression (15)

Referring to Figs. 6, 13, and 14 here, it can be seen that the higher the order is, the greater a distance from the reflection electrode to the emission point is. Therefore, desirably, a light-emitting unit lowest in m is adopted as the $n_{unit}$th light-emitting unit from the side where light emission is visually recognized and a light-emitting unit greater in m is adopted toward the side where light emission is visually recognized.

More specifically, desirably, a light-emitting unit having "m = 0" is adopted as the $n_{unit}$th light-emitting unit and a light-emitting unit having "m = $n_{unit}$-id$_{_unit}$" is adopted as the id$_{_unit}$th light-emitting unit.

Though the expression (15) represents a strict condition for phase matching, substantial matching is achieved even though a phase is shifted by approximately 10% from an integer multiple of 2π and a peak angle is close to a target. Therefore, a practically more preferable range of L is given in an expression (16) below.

$$\frac{\lambda}{2n_{EML}\cos\theta_{EML}}\left[m-\frac{\phi_m}{2\pi}-0.1\right]\leq d\leq\frac{\lambda}{2n_{EML}\cos\theta_{EML}}\left[m-\frac{\phi_m}{2\pi}+0.1\right]$$

$$\theta_{EML}=\sin^{-1}\left(\frac{\sin\theta}{n_{EML}}\right)$$

... Expression (16)

For example, when a condition of $n_{unit}$ = 3 is set, the position of the emission point satisfying m= 0 in the expression (15) is adopted for the third light-emitting unit from the side where light emission is visually recognized, and desirable position d of the emission point based on the expression (16) is given in an expression (17). Here, a condition of d3 = 56 nm is set for the third light-emitting unit from the side where light emission is visually recognized.

$$\frac{625\ \text{nm}}{2\times 1.74\times \cos 2.9^\circ}\left[0-\frac{-0.83}{2\pi}-0.1\right]\le d\le \frac{625\ \text{nm}}{2\times 1.74\times \cos 2.9^\circ}\left[0-\frac{-0.83}{2\pi}+0.1\right]$$

$$56\ \text{nm}\le d\le 92\ \text{nm}$$

... Expression (17)

[S60: Step of Determining Distance d from Reflection Electrode, of Emission Point of Each of First to ($n_{unit}$-1)th Light-Emitting Units From Side Where Light Emission Is Visually Recognized]

Distance d from the reflection electrode, of the emission point of each of the first to the ($n_{unit}$-1)th light-emitting units from the side where light emission is visually recognized is determined by using the expressions (15) and (16). As described previously, a light-emitting unit greater in m is desirably adopted toward the side where the emission point is visually recognized. Namely, an expression (18) below is desirably satisfied for the $id_{_unit}$th light-emitting unit from the side where light is visually recognized.

$$m = n_{unit} - id_{_unit}$$ ... Expression (18)

θ determined in S30 is adopted in the expressions (15) and (16), and distance d from the reflection electrode, of the $id_{_unit}$th light-emitting unit from the side where light is visually recognized is determined based on the expressions (15) and (16).

For example, distance d from the reflection electrode to the emission point of each of light-emitting unit 1 and light-emitting unit 2 when the condition of $n_{unit}$ = 3 is set will be described.

(1) Light-Emitting Unit 1

A condition of m = 3-1 = 2 is set. As determined in S30, a condition of θ =θ1=15 degrees is set. Based on the expression (16), a condition of 420 nm ≤ d1 ≤ 456 nm is satisfied. Here, a condition of d1 = 456 nm is set.

(2) Light-Emitting Unit 2

A condition of m = 3-2 = 1 is set. As determined in S30, a condition of θ = θ2 = 10 degrees is set. Based on the expression (16), a condition of 237 nm ≤ d1 ≤ 273 nm is satisfied. Here, a condition of d1 = 270 nm is set.

[S70: Step of Calculating Total Thickness L of Light-Emitting Function Layer, Peak Angle of Emission Intensity of Each of First to $n_{unit}$th Light-Emitting Units from Side Where Light Emission Is Visually Recognized, and Angular Distribution of Emission Intensity with All Light-Emitting Units Emitting Light and Finely Adjusting Total Thickness L of Light-Emitting Function Layer and Distance d from Reflection Electrode, of Each of First to $n_{unit}$th Points of Light Emission from Side Where Light Emission Is Visually Recognized]

Though a total thickness of the light-emitting function layer and distance d from the reflection electrode, of the emission point of each light-emitting unit are once determined in S10 to S70, each parameter is desirably finely adjusted based on a final angular distribution of emission intensity while all light-emitting units emit light.

In that case, L and d are desirably adjusted within a range of values shown in the expressions (13) and (15). A judging function as to whether or not a condition "D (θ) ≥ D (0) cosθ ($0<\theta<\theta_D<60$ degrees) being satisfied, where D (θ) represents angular dependency of emission intensity and $\theta_D$ represents a specific angle in simultaneous light emission from all light-emitting units" is desirably used as an indicator for adjustment. More specifically, a judging function I is defined as an expression (19) below and is desirably designed such that a value for I is maximal.

$$I = \int_0^{\theta_D} f\left(\frac{D(\theta)}{D(0)} - \cos\theta\right) d\theta$$

$$f(x) = \begin{cases} 1 & (x \geq 0) \\ 0 & (x < 0) \end{cases} \quad \text{... Expression (19)}$$

Though a step function is employed for f (x) in the expression (19), a smooth step function which can be differentiated is desirably used for facilitating convergence. Combination of a method of steepest descent, a conjugate gradient method, a linear programming method, and a genetic algorithm for desired characteristics is desirable for an optimization algorithm. In optimization, optimization in consideration of robustness is desirably carried out. A technique for calculating a design variable around a certain standard a plurality of times, making evaluation based on magnitude of variation in desired characteristics, and selecting a standard less in variation is desirable as a specific method for calculating robustness.

Fig. 16 shows a design example of a result of S10 to S70 above having been performed. Fig. 17 shows a result of calculation of angular dependency D(θ) of emission intensity while the light-emitting units emit light one by one. Deviation of a design value for a peak angle from a peak angle found in calculation by 1 to 2 degrees results from deviation in an interference condition associated with thickness L of the light-emitting function layer and position d of the emission point and strictly slight deviation in position of a peak angle. Such deviation can be overcome by taking deviation in peak angle of each light-emitting unit into an error function in S70.

Fig. 18 shows a result of calculation of angular dependency D(θ) of emission intensity while all light-emitting units simultaneously emit light in the design shown in Fig. 16. In the figure, light distribution expressed with cosθ is shown for comparison. The present embodiment satisfies the condition "an electroluminescent device in which two or more light-emitting units emitting light identical in color are vertically stacked, the electroluminescent device being configured such that a highest intensity angle of angular dependency of emission intensity in light emission from each light-emitting unit alone is different for each light-emitting unit, and $D(\theta) \geq D(0)\cos\theta$ ($0<\theta<\theta_D<60°$) being satisfied, where D (θ) represents angular dependency of emission intensity and $\theta_D$ represents a specific angle in simultaneous light emission from all light-emitting units," with a condition of θD = 20 degrees being set.

[1.5.2.2 Design with Oblique Intensity Being Prioritized]

In a design with oblique intensity being prioritized as well, the design method shown in Fig. 15 in [1.5.2.1 Design with Intensity in Front Being Prioritized] is basically used. The difference in step resides in S30 "step of determining peak intensity angle of each light-emitting unit." Here, only the "step of determining peak intensity angle of each light-emitting unit" will be described.

As described previously, the $n_{unit}$th light-emitting unit from the side where light emission is visually recognized which is closest to the reflection electrode is less in fluctuation in peak angle associated with fluctuation in thickness. Therefore, the $n_{unit}$th light-emitting unit is desirably designed to emit light at a desired oblique angle.

Here, an expression (20) below is desirably satisfied, with the number of light-emitting units being set to $n_{unit}$ and θ1, θ2, θ3, ..., $\theta n_{unit}$ representing highest intensity angles while the light-emitting units emit light individually from the side where light emission is visually recognized, respectively.

$$\theta_1 < \theta_2 < \ldots < \theta n_{unit} \quad \text{... Expression (20)}$$

By doing so, robustness against fluctuation in thickness, of a light-emitting unit emitting light at a most desired angle can be improved. With such a design, resistance to fluctuation in thickness of an intensity component at a specific angle can be improved. Applications as ensuring intensity in particular between 10 degrees and 40 degrees are required to achieve intensity at oblique angles. More specifically, the applications include a lighting apparatus aiming at external conveyance of information over a wide angle such as a road light, a marker lamp, a license plate light, a taillight, a parking light, a brake light, an auxiliary brake light, a backup light, a direction indicator, an auxiliary direction indicator, a hazard flasher, an emergency brake indicator, and a rear collision warning indicator of cars.

For example, in a design of three light-emitting units, an expression (21) below is desirably satisfied "with the number of light-emitting units being set to 3 and θ1, θ2, and θ3 representing highest intensity angles while light-emitting units emit light individually from the side where light emission is visually recognized, respectively.

$$\theta_1 < \theta_2 < \theta_3 \quad \text{... Expression (21)}$$

A more specific design in a case of the three light-emitting units shown in Fig. 5 will be described below.

[S10: Step of Determining the Number of Light-Emitting Units $n_{unit}$]

Here, a condition of $n_{unit}$ = 3 is set.

[S20: Step of Determining Order 1 Associated with Total Thickness L of Light-Emitting Function Layer as "l = $n_{unit}$-1"]

A condition of l = $n_{unit}$-1 = 2 is set.

[S30: Step of Determining Peak Intensity Angle of Each Light-Emitting Unit]

In an example where a peak angle is set at an interval of 5 degrees or smaller, a condition of θ1 = 15 degrees, θ2 = 20 degrees, and θ3 = 25 degrees is set. By doing so, a design with the barycenter of intensity being placed on a side of a relatively wide angle can be made. A condition of "θ1 < θ2 < θ3" is satisfied.

[S40: Step of Determining Total Thickness L of Light-Emitting Function Layer]

A condition of θ = θ3 = 25 degrees is set in the expression (13). An expression (22) below is obtained from calculation with a condition of 1 = 3-1 = 2 and $n_{EML}$ =1.74 being set and a condition of $\theta_{EML}$ = 14.1 degrees, ϕm = -0.83π, and ϕe = -0.64π being set based on the Fresnel reflectance theory. Here, a condition of L = 498 nm is set.

$$\frac{625\text{ nm}}{2\times 1.74\times\cos 14.1^\circ}\left[(3-1)-\frac{(-0.83-0.64)\pi}{2\pi}-0.1\right]\le L\le\frac{625}{2\times 1.74\times\cos 14.1^\circ}\left[(3-1)-\frac{(-0.83-0.64)\pi}{2\pi}-0.1\right]$$
$$\Leftrightarrow 488\text{ nm}\le L\le 525\text{ nm} \quad \text{... Expression (22)}$$

[S50: Step of Determining Distance d from Reflection Electrode, of Emission Point of $n_{unit}$th Light-Emitting Unit from Side Where Light Emission Is Visually Recognized]

Here, with a condition of $n_{unit}$ =3 being set, for the third light-emitting unit from the side where light emission is visually recognized, a position of the emission point satisfying m = 0 is adopted in the expression (15), and desirable position d of the emission point based on the expression (16) with a condition of θ = θ3 = 25 degrees being set is as shown in an expression (23) below. Here, a condition of d3 = 96 nm is set for the third light-emitting unit from the side where light emission is visually recognized.

$$\frac{625\text{ nm}}{2\times 1.74\times\cos 14.1^\circ}\left[0-\frac{-0.83}{2\pi}-0.1\right]\le d\le\frac{625\text{ nm}}{2\times 1.74\times\cos 14.1^\circ}\left[0-\frac{-0.83}{2\pi}+0.1\right]$$
$$58\text{ nm}\le d\le 96\text{ nm} \quad \text{... Expression (23)}$$

[S60: Step of Determining Distance d from Reflection Electrode, of Emission Point of Each of First to ($n_{unit}$-1)th Light-Emitting Units from Side Where Light Emission Is Visually Recognized]

Distance d from the reflection electrode, of the emission point of each of the first to the ($n_{unit}$-1)th light-emitting units from the side where light emission is visually recognized is determined by using the expressions (15) and (17). As described previously, a light-emitting unit greater in m is desirably adopted toward the side where the emission point is visually recognized. Namely, an expression (24) below is desirably satisfied for the $id_{_unit}$th light-emitting unit from the side where light is visually recognized.

$$m = n_{unit} - id_{_unit} \quad \text{... Expression (24)}$$

(1) Light-Emitting Unit 1

A condition of m = 3-1 = 2 is set. As determined in S30, a condition of $\theta = \theta 1 = 15$ degrees is set. Based on the expression (16), a condition of 420 nm $\leq$ d1 $\leq$ 457 nm is satisfied. Here, a condition of d1 = 420 nm is set.

(2) Light-Emitting Unit 2

A condition of m = 3-2 =1 is set. As determined in S30, a condition of $\theta = \theta 2 = 20$ degrees is set. Based on the expression (16), a condition of 241 nm $\leq$ d1 $\leq$ 278 nm is satisfied. Here, a condition of d1 = 241 nm is set.

[S70: Step of Calculating Total Thickness L of Light-Emitting Function Layer, Peak Angle of Emission Intensity of Each of First to $n_{unit}$th Light-Emitting Units from Side Where Light Emission Is Visually Recognized, and Angular Distribution of Emission Intensity with All Light-Emitting Units Emitting Light and Finely Adjusting Total Thickness L of Light-Emitting Function Layer and Distance d from Reflection Electrode, of Each of First to $n_{unit}$th Points of Light Emission from Side Where Light Emission Is Visually Recognized]

Though a total thickness of the light-emitting function layer and distance d from the reflection electrode, of the emission point of each light-emitting unit are once determined in S10 to S70, each parameter is desirably finely adjusted based on a final angular distribution of emission intensity while all light-emitting units emit light.

Fig. 19 shows a design example of a result of S10 to S70 having been performed. Fig. 20 shows a calculation example of angular dependency D ($\theta$) of emission intensity while the light-emitting units emit light one by one. Deviation of a design value for a peak angle from a peak angle found in calculation by 1 to 3 degrees results from deviation in an interference condition associated with thickness L of the light-emitting function layer and position d of the emission point and strictly slight deviation in position of a peak angle. Such deviation can be overcome by taking deviation in peak angle of each light-emitting unit into an error function in S70.

Fig. 21 shows a calculation example of angular dependency D ($\theta$) of emission intensity while all light-emitting units simultaneously emit light. Fig. 21 shows a light distribution expressed with $\cos\theta$ for comparison. The present embodiment satisfies the condition "an electroluminescent device in which two or more light-emitting units emitting light identical in color are vertically stacked, the electroluminescent device being configured such that a highest intensity angle of angular dependency of emission intensity in light emission from each light-emitting unit alone is different for each light-emitting unit, and $D(\theta) \geq D(0)\cos\theta$ ($0<\theta\leq\theta_D\leq60$ degrees) being satisfied, where D ($\theta$) represents angular dependency of emission intensity and $\theta_D$ represents a specific angle in simultaneous light emission from all light-emitting units" and the condition "$\theta 1 < \theta 2 < \theta 3$, with the number of light-emitting units being set to 3 and $\theta 1$, $\theta 2$, and $\theta 3$ representing highest intensity angles while the light-emitting units emit light individually from the side where light emission is visually recognized, respectively," with a condition of $\theta D = 30$ degrees being set. In particular, when such a condition is set, an effect of ensuring a large angular component close to $\theta D$ in a stable manner while certain front intensity is held is achieved.

[1.5.2 Design Example]

A desirable exemplary design including the design example described in [1.5.1] is shown below. Fig. 22 is the same as the design example shown in Fig. 16.

Fig. 23 is the same as the design example shown in Fig. 19. Fig. 24 shows a design example in which the number of light-emitting units is set to four. By thus setting the number of light-emitting units to four or more, various angular components can more finely be included. When the number of light-emitting units is set to four, a condition "$\theta 1 < \theta 2 < \theta 3 < \theta 4$" aims to ensure a component of $\theta 4$ closest to the reflection electrode in a stable manner, and therefore a condition "$\theta 1 < \theta 3 < \theta 2 < \theta 4$" also meets the requirements in the present embodiment.

Similarly, a condition "$\theta 1 > \theta 2 > \theta 3 > \theta 4$" for ensuring intensity in the front direction in a stable manner is similarly held even when it is changed to a condition $\theta 1 > \theta 3 > \theta 2 > \theta 4$." Namely, with peak angles while light-emitting units from the first light-emitting unit to the $n_{unit}$th unit individually emit light being defined as $\theta$ [1] to $\theta$ [$n_{unit}$-1], an expression (25) or (26) below shows a more generalized condition for a peak angle of emission intensity of each light-emitting unit in the present embodiment.

$$\theta[1] < \{\theta[2] \sim \theta[n_{unit}-1]\} < \theta[n_{unit}] \qquad \text{... Expression (25)}$$

$$\theta\,[1] > \{\theta\,[2] \sim \theta\,[n_{unit}-1]\} > \theta\,[n_{unit}] \quad \text{... Expression (26)}$$

When the condition in the expression (25) is satisfied, the light-emitting unit emitting light at a deepest angle can effectively be set at a position where fluctuation in peak angle associated with fluctuation in thickness is less and is suited for an application where a quantity of light emission is required over a wide angle. When the condition in the expression (26) is satisfied, the light-emitting unit emitting light at an angle closest to the front can effectively be set at a position where fluctuation in peak angle associated with fluctuation in thickness is less and is suited to an application where a quantity of light emission at an angle close to the front is required.

Furthermore, the conditions in the expressions (25) and (26) can realize a construction for keeping light intensity over a wider angle if conditions in expressions (27) and (28) below are satisfied.

$$0 < \theta\,[1] < \{\theta\,[2] \sim \theta\,[n_{unit}-1]\} > \theta\,[n_{unit}] \quad \text{... Expression (27)}$$

$$\theta\,[1] > \{\theta\,[2] \sim \theta\,[n_{unit}-1]\} > \theta\,[n_{unit}] \quad \text{... Expression (28)}$$

An effect of a certain quantity of front intensity being kept also in such a construction that interference is obliquely reinforced is made use of As compared with the conditions in the expressions (25) and (26), the expressions (27) and (28) can realize a construction in which light intensity is kept over a wide angle with a smaller number of light-emitting units.

The light-emitting units are desirably defined to vary in peak angle in the order of light-emitting units. Namely, an expression (29) or (30) below is desirably satisfied. By doing so, a quantity of deviation in interference from an adjacent light-emitting unit can be suppressed.

$$0 < \theta\,[1] < \theta\,[2] < \ldots < \theta\,[n_{unit}-1] < \theta\,[n_{unit}] \quad \text{... Expression (29)}$$

$$\theta\,[1] > \theta\,[2] > \ldots > \theta\,[n_{unit}-1] > \theta\,[n_{unit}] > 0 \quad \text{... Expression (30)}$$

[Second Embodiment]

[2.1 Example in Which First Relative Maximum of Angular Dependency of Emission Intensity Is Not Maximal Intensity]

Though the example in which the first relative maximum of angular dependency of emission intensity is defined as the maximal intensity has been described in the embodiment, the present embodiment is not limited thereto. An example in which a relative maximum other than the first relative maximum of angular dependency of emission intensity is defined as the maximal intensity in a case of three light-emitting units will be described below with reference to Fig. 5. A case that the relative maximum other than the first relative maximum of angular dependency of emission intensity is defined as the maximal intensity is desirably designed in the present embodiment such that an angle at which maximal intensity is attained is defined as a peak angle of angular dependency of emission intensity of that light-emitting unit.

Fig. 25 shows a design example in the model in Fig. 5. The design shown in Fig. 25 is configured such that a second relative maximum is maximal in light-emitting unit 3. Figs. 26 and 27 show angular dependency D ($\theta$) of emission intensity of each light-emitting unit while the light-emitting units emit light one by one and angular dependency D ($\theta$) of emission intensity while all of three light-emitting units emit light, respectively. By thus making use of a relative maximum of the higher order not lower than the second relative maximum, light having a component at a deep angle can be increased.

[2.2 Design Example of Two Light-Emitting Units]

The present embodiment is realized also by a device including two light-emitting units. Fig. 28 shows a model optically equivalent to a dual light-emitting unit device as in Fig. 5. Fig. 29 shows a result of a design for realizing the present embodiment similarly to the design including three light-emitting units. Figs. 30 and 31 show angular dependency D ($\theta$) of emission intensity of each light-emitting unit while the light-emitting units emit light one by one and angular dependency D ($\theta$) of emission intensity while all light-emitting units simultaneously emit light, respectively.

Thus, a construction satisfying a condition of $\theta1 < \theta2$ is realized. With a specific angle $\theta D$ = 30 degrees being

set, the requirement "D ($\theta$) $\geq$ D (0) cos$\theta$ ($0\leq\theta\leq\theta_D$<60 degrees)" in the present embodiment is met. By thus obtaining on the front side, a peak angle of the light-emitting unit on the side where light emission is visually recognized, intensity in the front direction can be designed in a stable manner against fluctuation in thickness, and at the same, time, light intensity can be ensured in a certain range of angles.

Fig. 32 shows a result of another design for realizing the present embodiment similarly in the two light-emitting units. Figs. 33 and 34 show D ($\theta$) of each light-emitting unit while the light-emitting units emit light one by one and D ($\theta$) while all light-emitting units simultaneously emit light, respectively. A construction satisfying a condition of $\theta 1 > \theta 2$ is thus realized.

With a specific angle $\theta$D = 30 degrees being set, the requirement "D ($\theta$) $\geq$ D (0) cos$\theta$ ($0\leq\theta<\theta_D$<60 degrees)" in the present embodiment is met. By thus obtaining on a side of a large angle, a peak angle of the light-emitting unit on the side where light emission is visually recognized, intensity in a direction of a large angle can be designed in a stable manner against fluctuation in thickness, and at the same time, light intensity can be ensured in a certain range of angles.

A device in Fig. 31 also represents an example of a construction satisfying an expression (31) below, with a specific angle $\theta$D = 31 degrees being set.

$$D(\theta) \geq D(0)\cos\theta \ (0\leq\theta\leq\theta_D) \text{ and}$$

$$D(\theta) < D(0)\cos\theta \ (\theta_D\leq\theta<90 \text{ degrees}) \quad \text{... Expression (31)}$$

Similarly, a device in Fig. 34 also represents an example of a construction satisfying an expression (32) below, with a specific angle $\theta$D = 33 degrees being set.

$$D(\theta) \geq D(0)\cos\theta \ (0\leq\theta\leq\theta_D) \text{ and}$$

$$D(\theta) < D(0)\cos\theta \ (\theta_D\leq\theta<90 \text{ degrees}) \quad \text{... Expression (32)}$$

By adopting such a construction, a light-emitting surface which is highly visually recognizable in a range of specific angles and is not seen in a region out of the specific range can be realized. Such characteristics are advantageous in realizing lighting aiming at conveyance of brightness information in a range of specific angles such as a traffic signal.

[Third Embodiment]

Though an embodiment of an electroluminescent device of a bottom-emission type has been described so far, the present embodiment is applicable to an electroluminescent device of a top-emission type as shown in Fig. 35. In this case, the side of visual recognition corresponds to a side of sealing member 120 opposite to reflection electrode 111a. In Fig. 35, a concept of a design of each embodiment described so far can be used, by successively providing numbers as light-emitting unit 1, light-emitting unit 2, light-emitting unit 3, and so on from the side where light emission is visually recognized.

[Fourth Embodiment]

The concept in each embodiment is applicable also to a light-emitting device which is transparent while light is not emitted, other than the electroluminescent device which emits light only on one side. In this case, the concept of the side where light emission is visually recognized is desirably in accordance with dependency of emission intensity on a direction of a surface. Namely, the concept in each embodiment described so far in which a direction of emission with higher light intensity is defined as the "side of principal visual recognition" when integral values for emission intensity on opposing surfaces are compared with each other is applied. Fig. 36 shows a schematic cross-sectional view of an electroluminescent device of a transparent emission type. The direction in which more light is emitted is thus desirably designed as the "side of principal visual recognition." Since an opposite side is seen through when light is turned off by making use of the transparent light-emitting device, a light-emitting device for externally conveying a state of emission of light such as a traffic signal which does not interrupt the sight is realized.

In such an application, when a ratio between the "side of principal visual recognition" and a "surface opposite to the side of principal visual recognition" is considered, a "maximum value for angular dependency of emission intensity on the side of principal visual recognition" is desirably at least two times, desirably at least 5 times, and further desirably at least 10 times the "maximum value for angular dependency of emission intensity of a surface opposite to the side of principal visual recognition." With such a construction, erroneous information is advantageously less likely to be conveyed to the "surface opposite to the side of visual recognition."

More specifically, an index of refraction of a transparent member (a material greater in thickness than a wavelength of emitted light, such as a resin film and a sealing member) which is located on a surface on the side of visual recognition and is in contact with the transparent electrode is desirably higher than an index of refraction of a transparent member (a material greater in thickness than a wavelength of emitted light, such as a resin film and a sealing member) which is located on a surface opposite to the side of visual recognition and is in contact with the transparent electrode. With such a construction, a state density of light on the side of visual recognition can be enhanced and more light can be provided on the side of visual recognition. Desirably, a real part of a complex relative permittivity of the transparent electrode on the side of the surface opposite to the side of visual recognition is negative and a real part of a complex relative permittivity of the transparent electrode located on the side of the surface on the side of visual recognition is positive. By doing so, a reflectance viewed from a light-emitting layer of the transparent electrode located on the side of the surface opposite to the side of visual recognition can be higher than a reflectance viewed from a light-emitting layer of the transparent electrode located on the side of the surface on the side of visual recognition and more light can be provided to the side of visual recognition. A method of making light emission uneven is not limited to this method, and for example, light emission can be uneven toward one side by using an optical member such as a half mirror or a polarizing mirror.

[Description of Terms Used in Each Embodiment]

Terms used in each embodiment will be described below.

[Peak Angle of Light Intensity While Each Light-Emitting Unit Alone Emits Light]

In the text, a denotation a "peak angle of emission intensity" or simply a "peak angle" may be given. Definition of a peak angle will be described below. Figs. 37 and 38 show figures for description. Referring to Fig. 37, surface-emitting panel 110 is arranged in air, a detector 600 is arranged in a direction at an angle $\theta$ from a surface normal to surface-emitting panel 110, and angular dependency $D(\theta)$ of light intensity is determined. Here, surface-emitting panel 110 is set to a state that only one light-emitting unit emits light.

In Figs. 37 and 38, detector 600 measures luminance or intensity. A luminance is measured under the definition by Commission Internationale de l'Eclairage (CIE) by multiplying wavelength dependency of optical power by a luminosity factor. In measurement of intensity, light intensity is measured as it is. A more uniform luminance can be realized or a color can be corrected by mixing fluorescent particles which absorb emitted light in a scattering member. In that case, intensity is desirably weighted by a sensitivity wavelength of a fluorescent member.

Referring to Fig. 38, "dependency on an angle to a surface normal to a light-emitting portion, of intensity in a transparent member 113 of light generated in light-emitting region 111" refers to a quantity obtained by measurement as to at which angles light generated in light-emitting region 111 of a surface-emitting panel is distributed in transparent member 113.

Experimentally, a hemispherical lens 700 which is sufficiently (for example, 10 times) larger than an area of light-emitting region 111 and has an index of refraction as high as transparent member 113 is prepared, a space between transparent member 113 and hemispherical lens 700 is filled with a matching oil for matching of an index of refraction, and dependency on an angle to a normal to a light-emitting surface, of light intensity is measured. Though a fluorescent member may be mixed in a scattering member as described previously, light intensity is desirably weighted by a sensitivity wavelength of fluorescence in that case.

For example, when light-emitting unit 1 alone in the surface-emitting panel shown in Fig. 4 is subjected to measurement, only a light-emitting layer in light-emitting unit 1 emits light. More specifically, angular dependency $D(\theta)$ of light intensity is desirably calculated in a state that only light-emitting unit 1 emits light, by using a model shown in Figs. 37 and 38 with the use of an optical simulator.

Desirably, an optically equivalent device may be produced and measurement in air may be conducted.

$D(\theta)$ thus measured is plotted on a graph and an angle at which a relative maximum value is obtained is found. Though two or more peak angles may appear depending on a design, a relative maximum peak highest in intensity or a relative maximum peak closest to the front is made use of in each embodiment.

For light intensity, either integral intensity of a total wavelength or a luminance weighted by a luminosity factor can be employed. In particular, since light intensity adapted to the sense of sight of a human can be measured, a luminance weighted by a luminosity factor is desirably employed.

The present embodiment requires that an expression (33) below be satisfied in connection with specific angle $\theta D$, and meaning thereof is supplementarily described.

$$D(\theta) \geq D(0)\cos\theta \ (0<\theta\leq\theta_D\leq 60 \text{ degrees}) \quad \text{... Expression (33)}$$

In general, an expression (34) below is held for angular dependency of light intensity of perfect diffusion light.

$$D(\theta) = D(0)\cos\theta \quad \text{... Expression (34)}$$

Here, D (0) represents front intensity. Therefore, intensity higher than D (0) cosθ means that visual recognizability is higher than a plate which reflects light as being diffused. This is characteristics important in applications for lighting (a downlight for decorative lighting, a colored spotlight in a theater, a colored flash light for signaling, a traffic light, and colored headlight, backup light, and brake light of a vehicle) for conveying information with good visual recognizability in a range of specific angles. In such applications, light emission is desirably not much observed at an angle equal to or greater than a specific angle. Therefore, an expression (35) below is more desirably satisfied.

$$D(\theta) \geq D(0)\cos\theta \ (0<\theta\leq\theta_D) \text{ and}$$
$$D(\theta) < D(0)\cos\theta \ (\theta_D<\theta<90 \text{ degrees}, 0\leq\theta_D\leq 60 \text{ degrees}) \quad \text{... Expression (35)}$$

[Wavelength Used in Design]

A wavelength used in design is desirably set in accordance with definition of light intensity. For example, when attention is paid to intensity of a peak wavelength, calculation is desirably made with a peak wavelength. In a case of integral intensity of a total wavelength, a design is desirably made with a centroidal wavelength of an emission spectrum. When a luminance weighted by a luminosity factor is used, a design is desirably made by using a centroidal wavelength after intensity in emission spectrum is weighted by a luminosity factor. By doing so, final light intensity can be designed to meet the requirement in the present embodiment.

Though a red device having a wavelength of 625 nm has been described in the design example, each embodiment is not limited to red, and an embodiment can be realized, for example, with a blue, green, or yellow device. More specifically, an embodiment is applicable to any electroluminescent device having light emission components of visible light having wavelengths from 380 nm to 780 nm. Similar design guidelines are also applicable to a device other than a device adapted to visible light, such as an infrared light source (for remote controllers and data communication) and an ultraviolet light source (a sterilization lamp, a photolithography exposure apparatus, and lighting for an ultraviolet excited fluorescence microscope) for ensuring emission intensity in a range of specific angles.

[Phase Variation ϕm Due to Reflection at Interface Between Light-Emitting Function Layer and Reflection Electrode]

A physical quantity represented by a phase of A, with A representing a Fresnel coefficient of a light-emitting function layer and a reflection electrode. The Fresnel coefficient can be calculated with an existing electromagnetic field analysis technique such as a transfer matrix method, a finite element method, a rigorous coupled-wave analysis, and a finite-difference time-domain method. Attention should be paid to the fact that the Fresnel coefficient varies depending on an angle. In each embodiment, a coefficient of reflection of S waves particularly high in reflectance is desirably employed, and S waves and P waves are desirably weighted in accordance with light intensity.

[Phase Variation ϕE Due to Reflection at Interface Between Light-Emitting Function Layer and Transparent Electrode When Transparent Electrode and Transparent Substrate Are Viewed from Light-Emitting Function Layer]

A physical quantity represented by a phase of A, with A representing a Fresnel coefficient at an interface between a light-emitting function layer and a transparent electrode when an optical multi-layered film constituted of a light-emitting function layer/a transparent electrode/a transparent substrate is considered. The Fresnel coefficient can be calculated with an existing electromagnetic field analysis technique such as a transfer matrix method, a finite element method, a rigorous coupled-wave analysis, and a finite-difference time-domain method. Attention should be paid to the fact that the Fresnel coefficient varies depending on an angle. In each embodiment, a coefficient of reflection of S waves particularly high in reflectance is desirably employed, and S waves and P waves are desirably weighted in accordance with light intensity.

[Transparent Electrode (Supplementary Description)]

A small-thickness metal is exemplified as a transparent electrode, and a material in Japanese Laid-Open Patent Publication No. 2014-182997 is desirably used for an underlying layer. Japanese Laid-Open Patent Publication No. 2014-182997 shows that continuity of a small-thickness metal electrode can be improved and transmittance can be enhanced by forming a nitrogen-containing underlying layer before a transparent electrode.

A transparent oxide semiconductor electrode (ITO or IZO) having a work function suitable for injection of holes is employed for a transparent electrode. For a transparent electrode layer, in addition to a transparent oxide semiconductor, a conductive resin which can be produced at low cost with an application method may be employed. A perylene derivative or a fullerene derivative such as [6,6]-phenyl-C61-butyric acid methyl ester (PCBM) is available as a conductive resin material used for an electron transfer electrode. For example, in a case of PCBM, an optical constant of visible light is (index of refraction $n = 2.2$ and extinction coefficient $k = 0.25$) and a reflectance of an electrode viewed from a light-emitting function layer is higher than that of a resin having an index of refraction of 1.5.

Examples of a conductive resin material used for a hole transfer electrode include poly(3,4-ethylenedioxythiophene) (PEDOT)/poly(4-styrenesulfonate) (PSS), poly(3-hexylthiophene) (P3HT), poly(3-octylthiophene) (P3OT), poly(3-dodecylthiophene-2,5-diyl) (P3DDT), and a copolymer of fluorene and bithiophene (F8T2).

For example, in a case of PEDOT/PSS, an optical constant of visible light is (index of refraction $n = 1.5$ and extinction coefficient $k = 0.01$), and a reflectance of an electrode viewed from the light-emitting function layer has a value comparable to that of a resin having an index of refraction of $n = 1.5$ and the reflectance is relatively lower than that of PCBM. In order to enhance electrical conductivity of a transparent electrode, a metal mesh, a metal nanowire, or metal nanoparticles may be used together. In this case, with higher electron conductivity of an electrode including a metal nanowire, an average index of refraction tends to be lower and a reflectance viewed from a light-emitting layer tends to be high. In carrying out each embodiment, light of which waveguide mode has been diffused by a transparent electrode material low in reflectance viewed from a light-emitting layer can efficiently be extracted to a transparent substrate, which is desirable.

Though the embodiments of the present invention have been described, it should be understood that the embodiments disclosed herein are illustrative and non-restrictive in every respect. The scope of the present invention is defined by the terms of the claims and is intended to include any modifications within the scope and meaning equivalent to the terms of the claims.

## Claims

**1.** An electroluminescent device in which two or more light-emitting units which emit light identical in color are stacked, the electroluminescent device being configured such that a first relative maximal angle or a highest intensity angle viewed in a front direction of angular dependency of emission intensity in light emission from each light-emitting unit (110A, 110B, 110C) alone is different for each light-emitting unit (110A, 110B, 110C), and
$D(\theta) \geq D(0)\cos\theta$ ($0 \leq 6 \leq \theta_D \leq 60$ degrees) ... Expression (1) being satisfied, where $D(\theta)$ represents angular dependency of emission intensity and $\theta_D$ represents a specific angle in simultaneous light emission from all the light-emitting units (110A, 110B, 110C).

**2.** The electroluminescent device according to claim 1, wherein
$\theta_D$ is set to 30 degrees.

**3.** The electroluminescent device according to claim 1 or 2, wherein
a condition of $\theta 1 > \theta 2 > \theta 3$ is satisfied, with the number of the light-emitting units (110A, 110B, 110C) being set to 3 and $\theta 1$, $\theta 2$, and $\theta 3$ representing highest intensity angles when the light-emitting units (110A, 110B, 110C) emit light individually from a side where light emission is visually recognized, respectively.

**4.** The electroluminescent device according to claim 1 or 2, wherein
a condition of $\theta 1 < \theta 2 < \theta 3$ is satisfied, with the number of the light-emitting units (110A, 110B, 110C) being set to 3 and $\theta 1$, $\theta 2$, and $\theta 3$ representing highest intensity angles when the light-emitting units (110A, 110B, 110C) emit light individually from a side where light emission is visually recognized, respectively.

**5.** The electroluminescent device according to claim 1 or 2, wherein
a condition of $\theta 1 < \theta 3 < \theta 2$ is satisfied, with the number of the light-emitting units (110A, 110B, 110C) being set to 3 and $\theta 1$, $\theta 2$, and $\theta 3$ representing highest intensity angles when the light-emitting units (110A, 110B, 110C) emit light individually from a side where light emission is visually recognized, respectively.

**6.** The electroluminescent device according to claims 1 or 2, wherein the number of the light-emitting units is set to four or more.

FIG.1

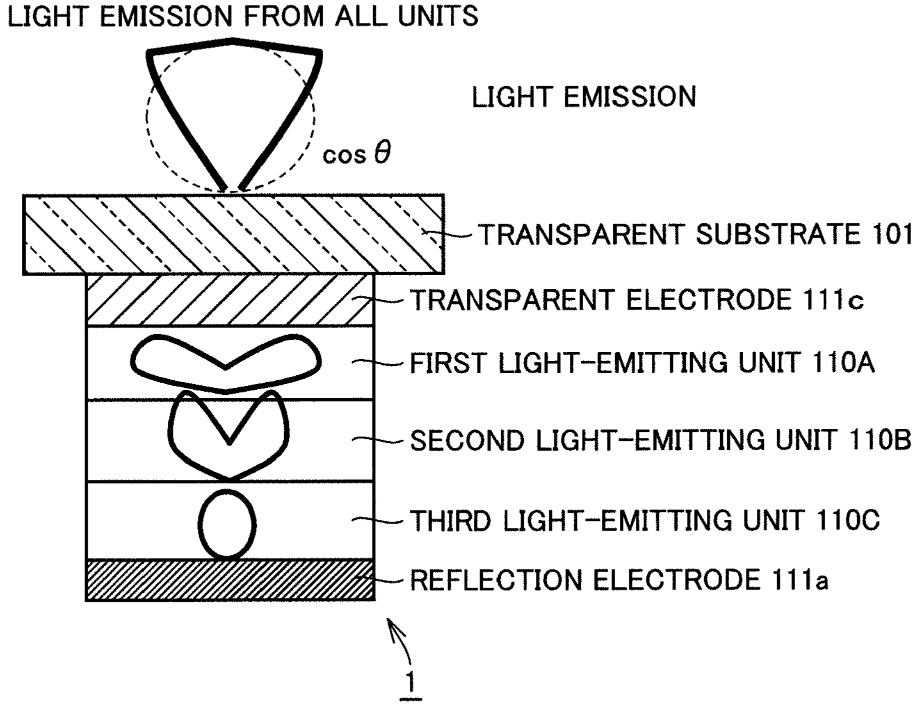
LIGHT EMISSION FROM ALL UNITS
LIGHT EMISSION
cos θ
TRANSPARENT SUBSTRATE 101
TRANSPARENT ELECTRODE 111c
FIRST LIGHT-EMITTING UNIT 110A
SECOND LIGHT-EMITTING UNIT 110B
THIRD LIGHT-EMITTING UNIT 110C
REFLECTION ELECTRODE 111a
1

FIG.2

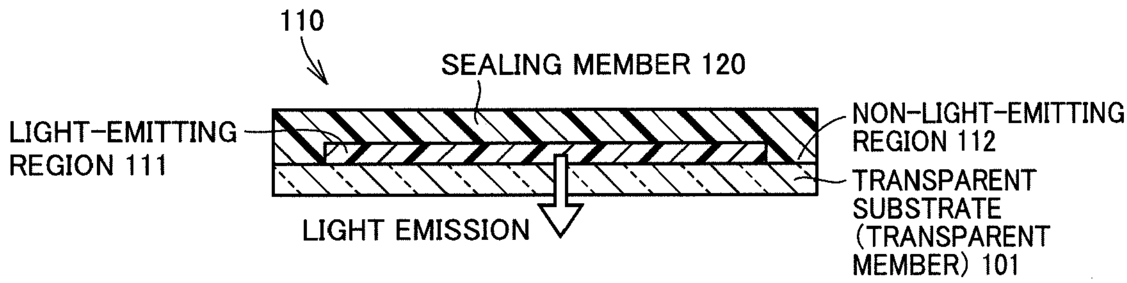
110
SEALING MEMBER 120
LIGHT-EMITTING REGION 111
NON-LIGHT-EMITTING REGION 112
TRANSPARENT SUBSTRATE (TRANSPARENT MEMBER) 101
LIGHT EMISSION

FIG.3

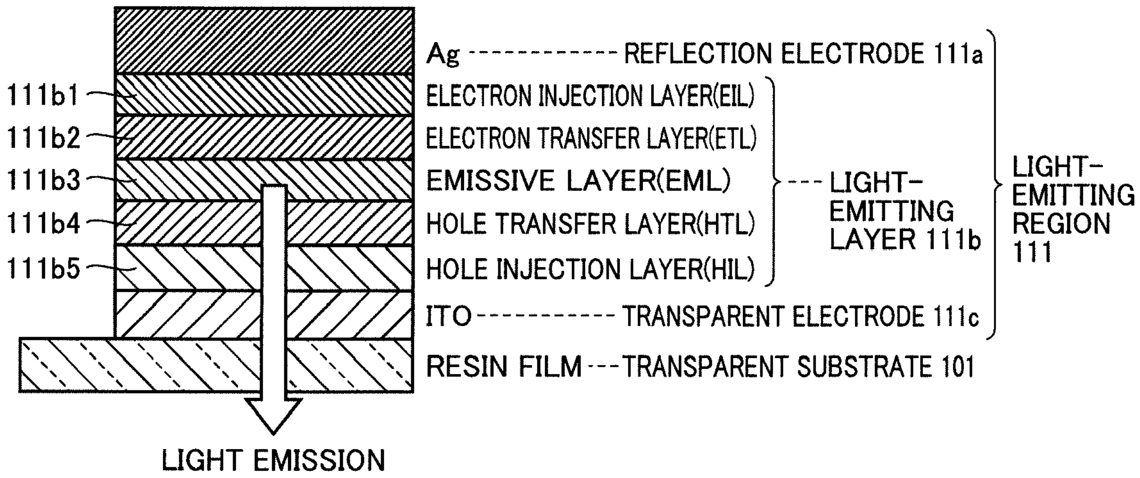
111b1
111b2
111b3
111b4
111b5
Ag ------------ REFLECTION ELECTRODE 111a
ELECTRON INJECTION LAYER(EIL)
ELECTRON TRANSFER LAYER(ETL)
EMISSIVE LAYER(EML)
HOLE TRANSFER LAYER(HTL)
HOLE INJECTION LAYER(HIL)
LIGHT-EMITTING LAYER 111b
LIGHT-EMITTING REGION 111
ITO ----------- TRANSPARENT ELECTRODE 111c
RESIN FILM --- TRANSPARENT SUBSTRATE 101
LIGHT EMISSION

FIG.4

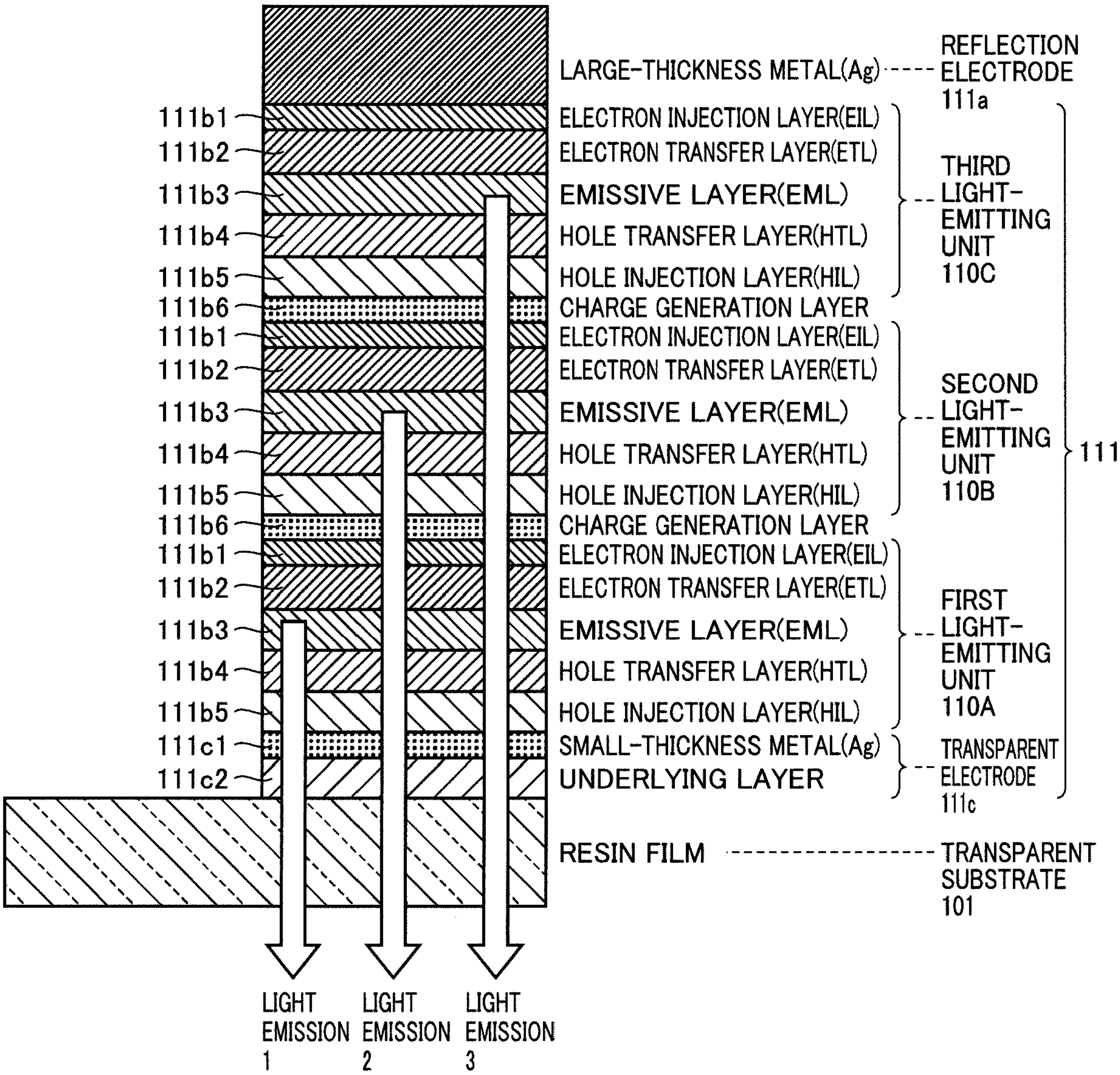
LARGE-THICKNESS METAL(Ag)
REFLECTION ELECTRODE 111a
111b1 ELECTRON INJECTION LAYER(EIL)
111b2 ELECTRON TRANSFER LAYER(ETL)
111b3 EMISSIVE LAYER(EML)
111b4 HOLE TRANSFER LAYER(HTL)
111b5 HOLE INJECTION LAYER(HIL)
THIRD LIGHT-EMITTING UNIT 110C
111b6 CHARGE GENERATION LAYER
111b1 ELECTRON INJECTION LAYER(EIL)
111b2 ELECTRON TRANSFER LAYER(ETL)
111b3 EMISSIVE LAYER(EML)
111b4 HOLE TRANSFER LAYER(HTL)
111b5 HOLE INJECTION LAYER(HIL)
SECOND LIGHT-EMITTING UNIT 110B
111b6 CHARGE GENERATION LAYER
111b1 ELECTRON INJECTION LAYER(EIL)
111b2 ELECTRON TRANSFER LAYER(ETL)
111b3 EMISSIVE LAYER(EML)
111b4 HOLE TRANSFER LAYER(HTL)
111b5 HOLE INJECTION LAYER(HIL)
FIRST LIGHT-EMITTING UNIT 110A
111c1 SMALL-THICKNESS METAL(Ag)
111c2 UNDERLYING LAYER
TRANSPARENT ELECTRODE 111c
111
RESIN FILM
TRANSPARENT SUBSTRATE 101
LIGHT EMISSION 1
LIGHT EMISSION 2
LIGHT EMISSION 3

FIG.5

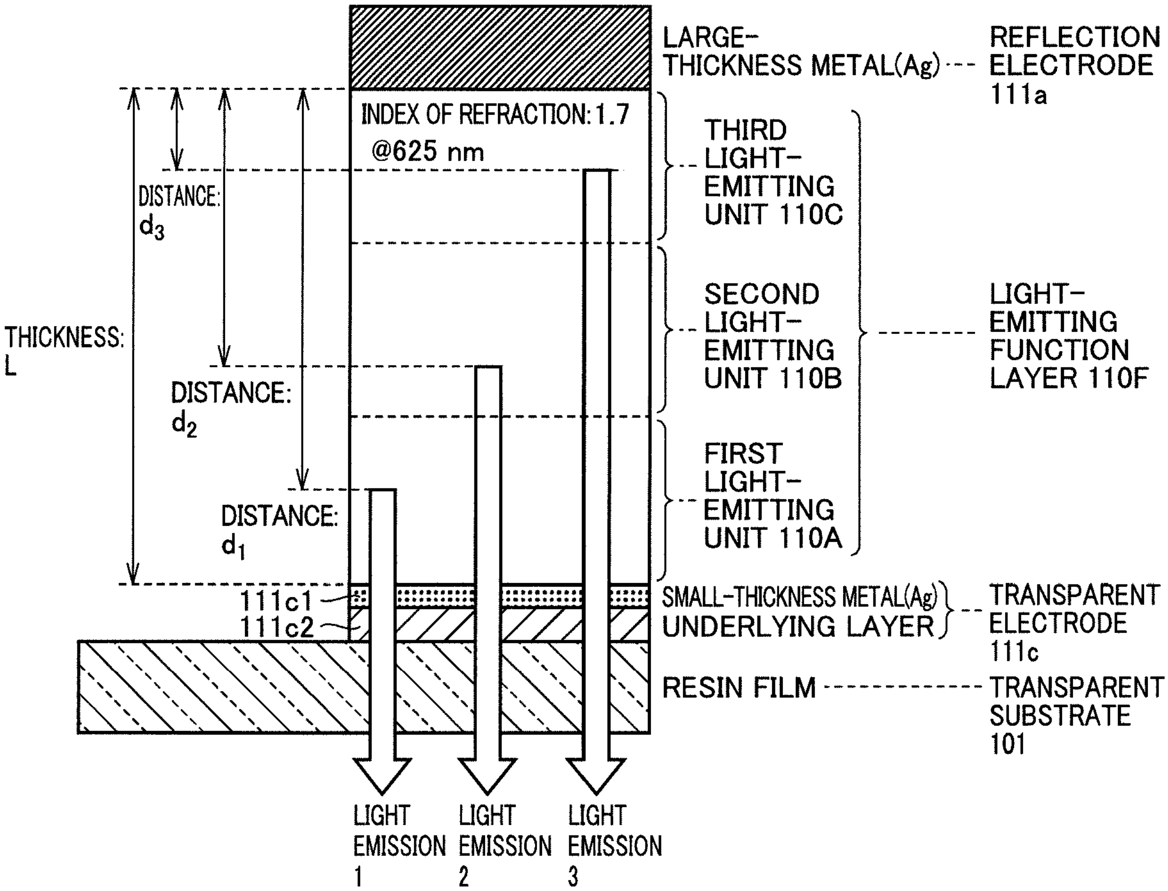
LARGE-THICKNESS METAL(Ag)
REFLECTION ELECTRODE 111a
INDEX OF REFRACTION: 1.7 @625 nm
THIRD LIGHT-EMITTING UNIT 110C
SECOND LIGHT-EMITTING UNIT 110B
FIRST LIGHT-EMITTING UNIT 110A
LIGHT-EMITTING FUNCTION LAYER 110F
DISTANCE: $d_3$
DISTANCE: $d_2$
DISTANCE: $d_1$
THICKNESS: L
111c1
111c2
SMALL-THICKNESS METAL(Ag)
UNDERLYING LAYER
TRANSPARENT ELECTRODE 111c
RESIN FILM
TRANSPARENT SUBSTRATE 101
LIGHT EMISSION 1
LIGHT EMISSION 2
LIGHT EMISSION 3

FIG.6

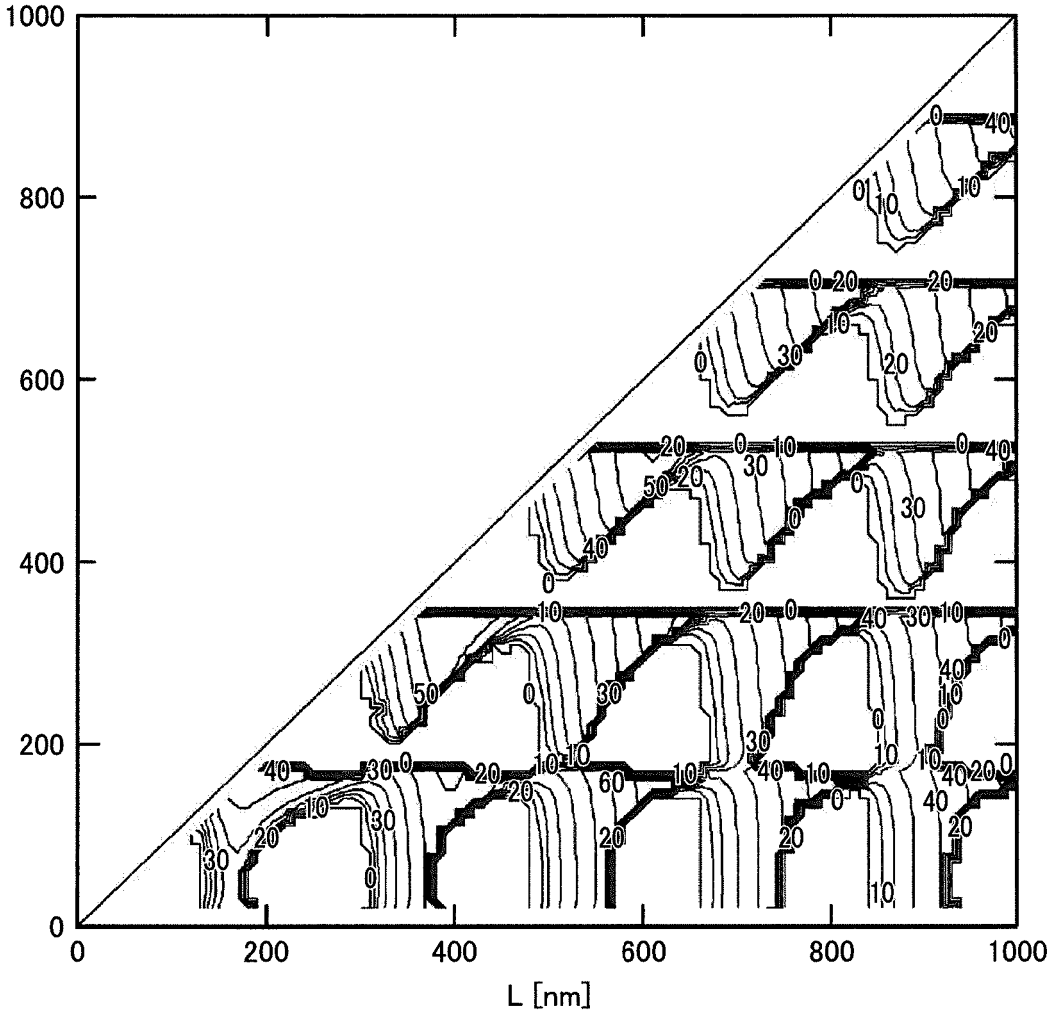

FIG.7

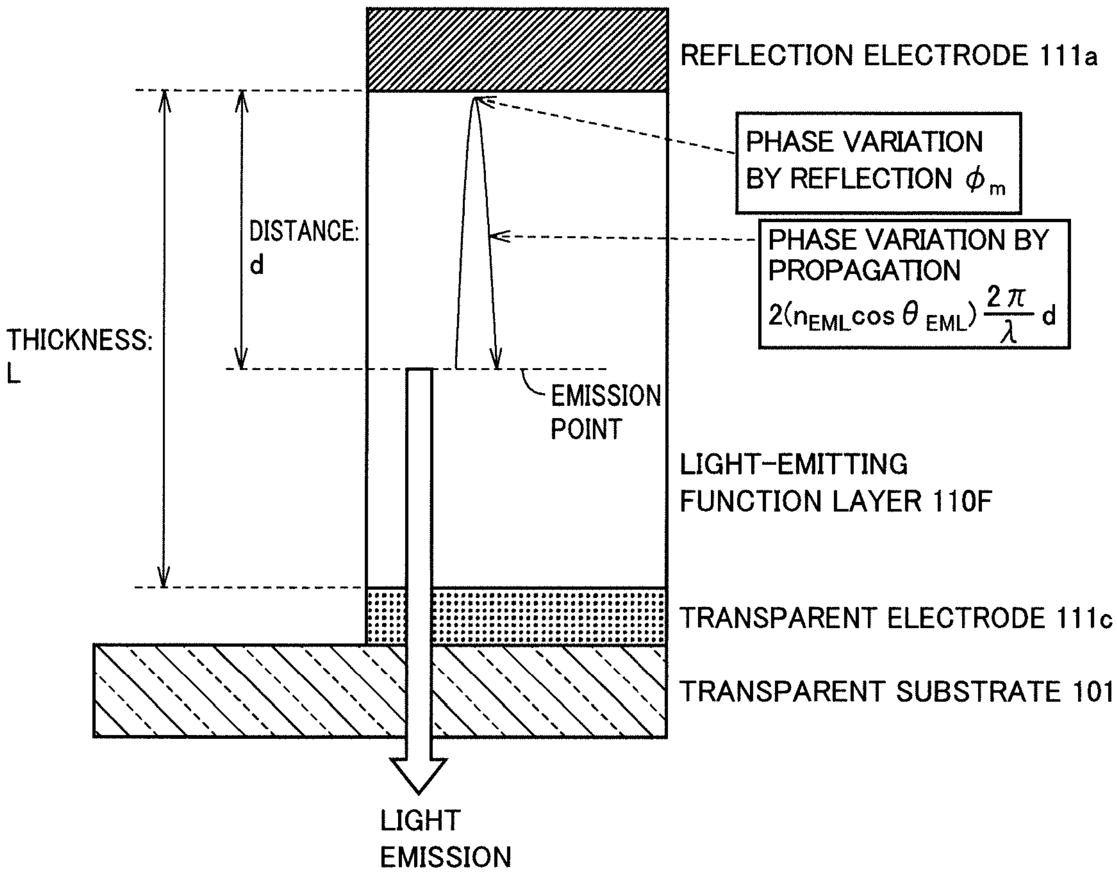
REFLECTION ELECTRODE 111a
PHASE VARIATION BY REFLECTION $\phi_m$
PHASE VARIATION BY PROPAGATION $2(n_{EML}\cos\theta_{EML})\frac{2\pi}{\lambda}d$
DISTANCE: d
THICKNESS: L
EMISSION POINT
LIGHT-EMITTING FUNCTION LAYER 110F
TRANSPARENT ELECTRODE 111c
TRANSPARENT SUBSTRATE 101
LIGHT EMISSION

FIG.8

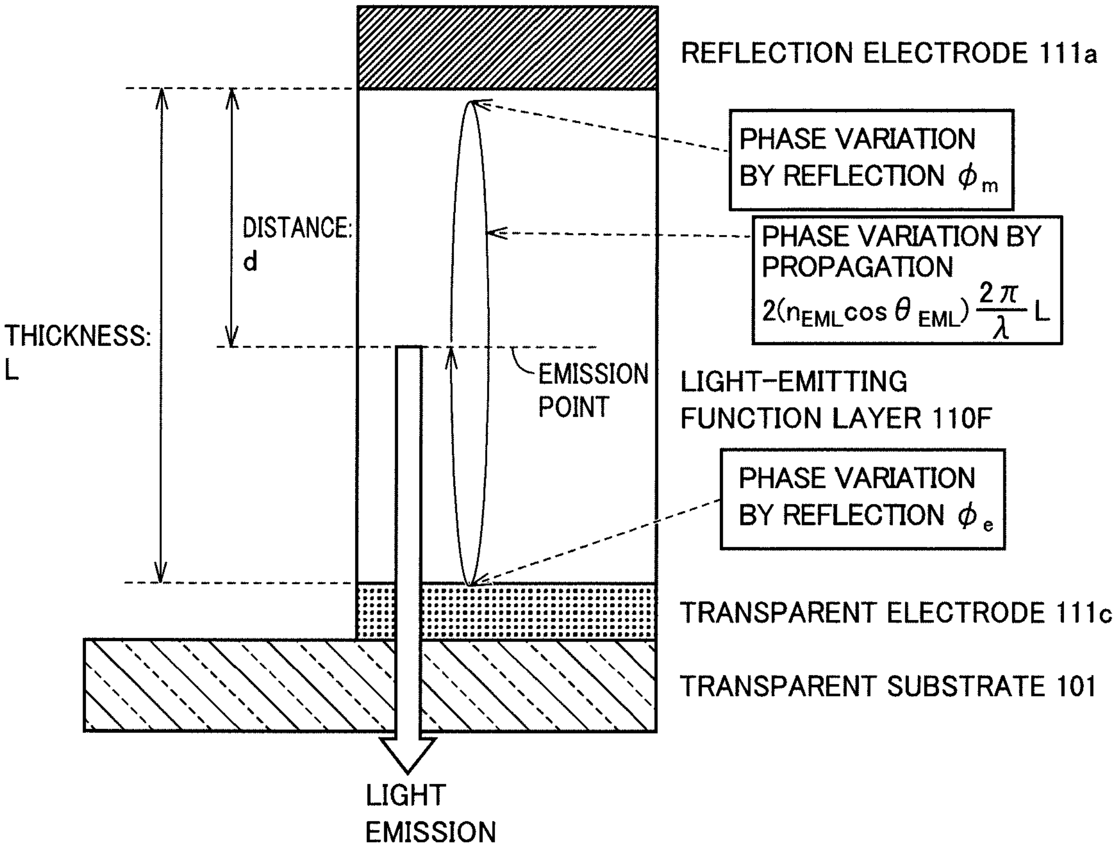


FIG.9

CONDITION (a)

| m | d [nm] |
|---|---|
| 0 | 74.6 |
| 1 | 254.7 |
| 2 | 434.8 |
| 3 | 614.9 |
| 4 | 795.0 |
| 5 | 975.1 |
| 6 | 1155.2 |
| 7 | 1335.3 |
| 8 | 1515.4 |
| 9 | 1695.6 |
| 10 | 1875.7 |
| 11 | 2055.8 |

FIG.10

CONDITION (b)

| l | L [nm] |
|---|---|
| 0 | 131.6 |
| 1 | 311.7 |
| 2 | 491.8 |
| 3 | 671.9 |
| 4 | 852.0 |
| 5 | 1032.1 |
| 6 | 1212.2 |
| 7 | 1392.3 |
| 8 | 1572.4 |
| 9 | 1752.5 |
| 10 | 1932.6 |
| 11 | 2112.8 |

FIG.11

CONDITION (a)

| m | d [nm] |
|---|---|
| 0 | 77.4 |
| 1 | 263.1 |
| 2 | 448.8 |
| 3 | 634.5 |
| 4 | 820.2 |
| 5 | 1005.9 |
| 6 | 1191.6 |
| 7 | 1377.3 |
| 8 | 1563.0 |
| 9 | 1748.7 |
| 10 | 1934.4 |
| 11 | 2120.1 |

FIG.12

CONDITION (b)

| l | L [nm] |
|---|---|
| 0 | 136.7 |
| 1 | 322.4 |
| 2 | 508.1 |
| 3 | 693.8 |
| 4 | 879.5 |
| 5 | 1065.2 |
| 6 | 1250.9 |
| 7 | 1436.6 |
| 8 | 1622.3 |
| 9 | 1808.0 |
| 10 | 1993.7 |
| 11 | 2179.4 |

FIG.13

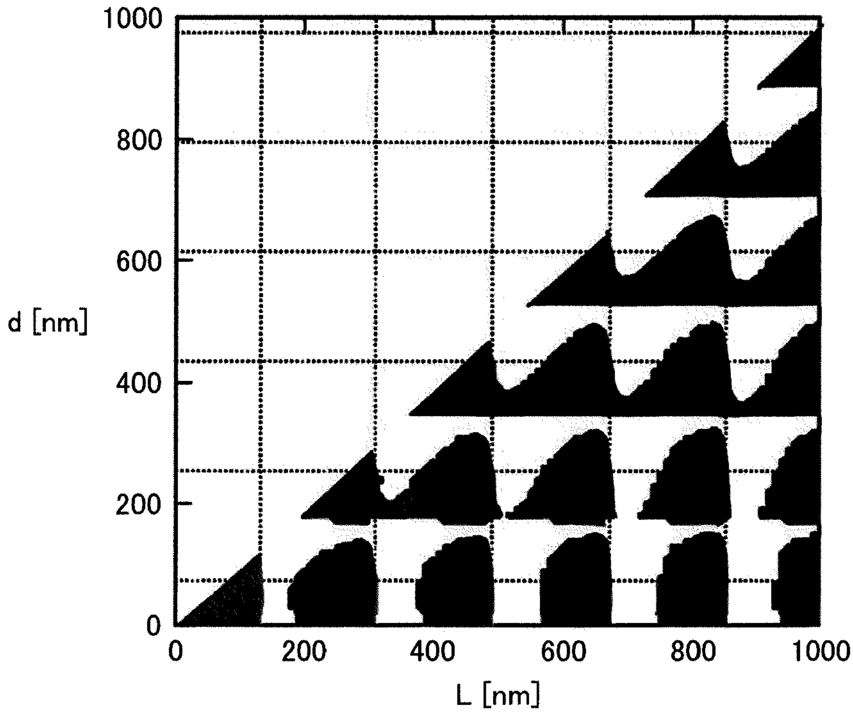

FIG.14

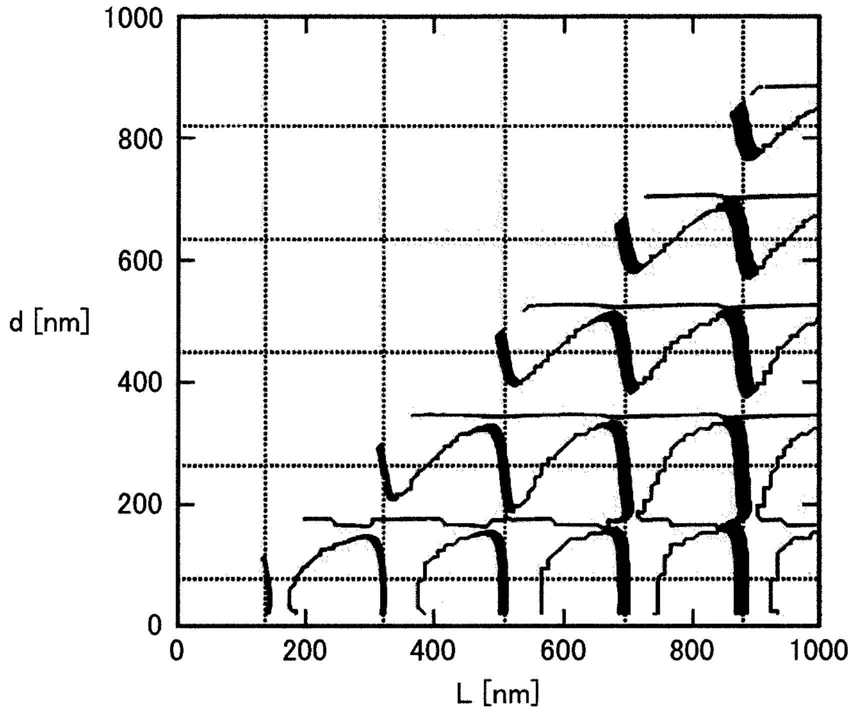

FIG.15

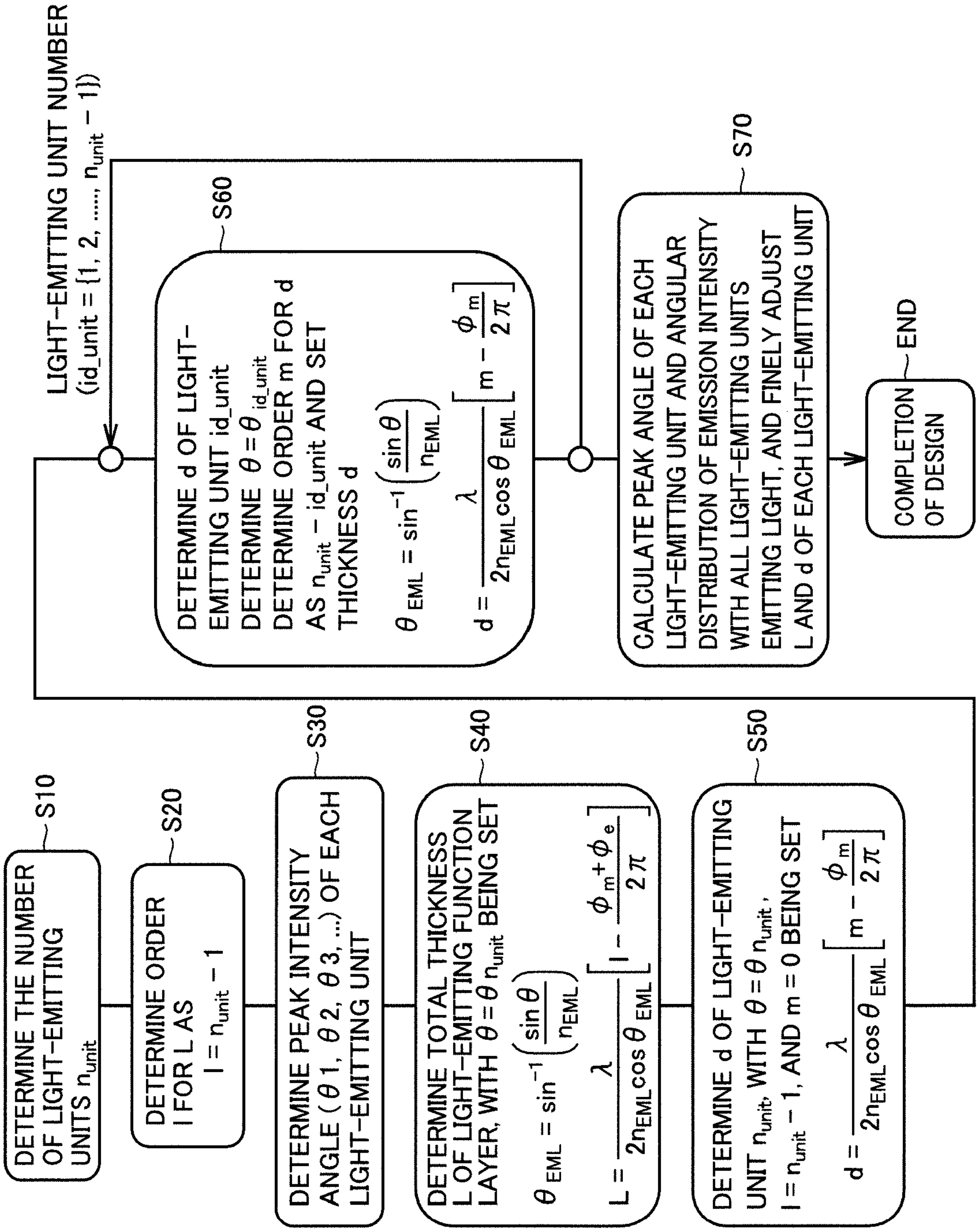
DETERMINE THE NUMBER OF LIGHT-EMITTING UNITS $n_{unit}$
S10
DETERMINE ORDER l FOR L AS
$l = n_{unit} - 1$
S20
DETERMINE PEAK INTENSITY ANGLE ($\theta 1$, $\theta 2$, $\theta 3$, ...) OF EACH LIGHT-EMITTING UNIT
S30
DETERMINE TOTAL THICKNESS L OF LIGHT-EMITTING FUNCTION LAYER, WITH $\theta = \theta\, n_{unit}$ BEING SET
$\theta_{EML} = \sin^{-1}\left(\frac{\sin\theta}{n_{EML}}\right)$
$L = \frac{\lambda}{2n_{EML}\cos\theta_{EML}}\left[l - \frac{\phi_m + \phi_e}{2\pi}\right]$
S40
DETERMINE d OF LIGHT-EMITTING UNIT $n_{unit}$, WITH $\theta = \theta\, n_{unit}$, $l = n_{unit} - 1$, AND m = 0 BEING SET
$d = \frac{\lambda}{2n_{EML}\cos\theta_{EML}}\left[m - \frac{\phi_m}{2\pi}\right]$
S50
LIGHT-EMITTING UNIT NUMBER
(id_unit = {1, 2, ....., $n_{unit} - 1$})
DETERMINE d OF LIGHT-EMITTING UNIT id_unit
DETERMINE $\theta = \theta_{id_unit}$
DETERMINE ORDER m FOR d AS $n_{unit}$ - id_unit AND SET THICKNESS d
$\theta_{EML} = \sin^{-1}\left(\frac{\sin\theta}{n_{EML}}\right)$
$d = \frac{\lambda}{2n_{EML}\cos\theta_{EML}}\left[m - \frac{\phi_m}{2\pi}\right]$
S60
CALCULATE PEAK ANGLE OF EACH LIGHT-EMITTING UNIT AND ANGULAR DISTRIBUTION OF EMISSION INTENSITY WITH ALL LIGHT-EMITTING UNITS EMITTING LIGHT, AND FINELY ADJUST L AND d OF EACH LIGHT-EMITTING UNIT
S70
COMPLETION OF DESIGN
END

FIG.16

| | |
|---|---|
| nunit | 3 |

| | UNIT NUMBER | DESIGN OF PEAK ANGLE [deg] | ORDER FOR THICKNESS L | ORDER FOR POSITION d | L [nm] | d [nm] | CALCULATION OF PEAK ANGLE [deg] |
|---|---|---|---|---|---|---|---|
| UNIT 3 | 3 | 5 | 3-1=2 | 3-3=0 | 491 | 56 | 7 |
| UNIT 2 | 2 | 10 | 3-1=2 | 3-2=1 | 491 | 270 | 11 |
| UNIT 1 | 1 | 15 | 3-1=2 | 3-1=2 | 491 | 456 | 14 |

FIG.17

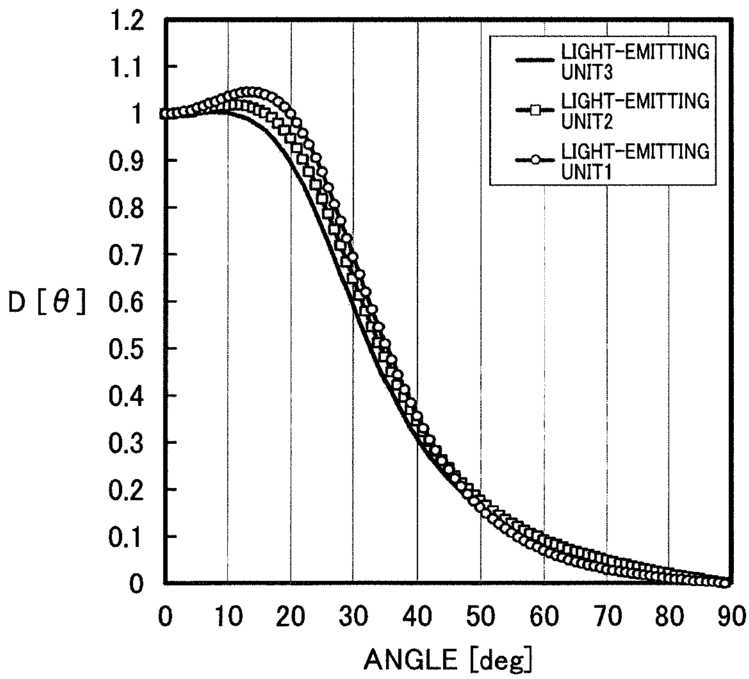

FIG.18

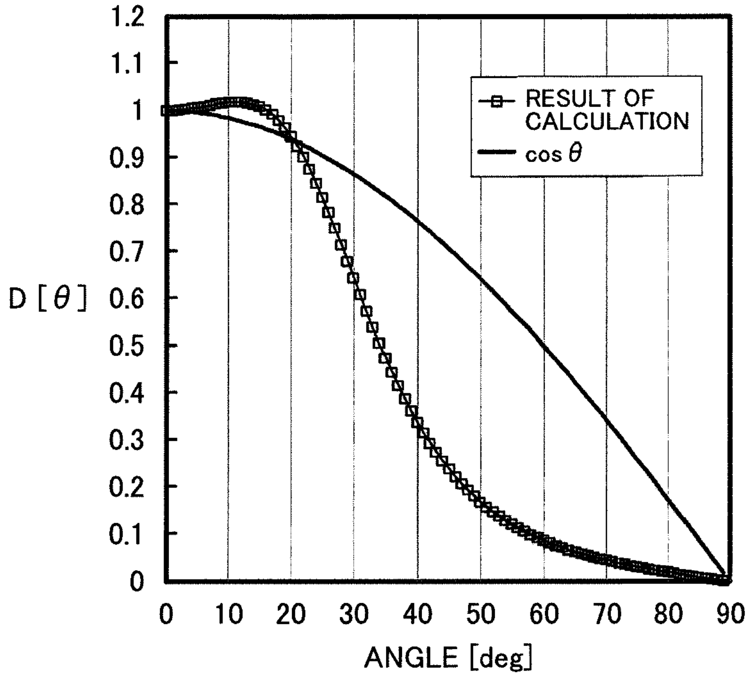


FIG.19

| | |
|---|---|
| nunit | 3 |

| LIGHT-EMITTING UNIT | LIGHT-EMITTING UNIT NUMBER | DESIGN OF PEAK ANGLE [deg] | ORDER FOR THICKNESS L | ORDER FOR POSITION d | L [nm] | d [nm] | CALCULATION OF PEAK ANGLE [deg] |
|---|---|---|---|---|---|---|---|
| UNIT 3 | 3 | 25 | 3-1=2 | 3-3=0 | 502 | 96 | 23 |
| UNIT 2 | 2 | 20 | 3-1=2 | 3-2=1 | 502 | 241 | 20 |
| UNIT 1 | 1 | 15 | 3-1=2 | 3-1=2 | 502 | 420 | 18 |

FIG.20

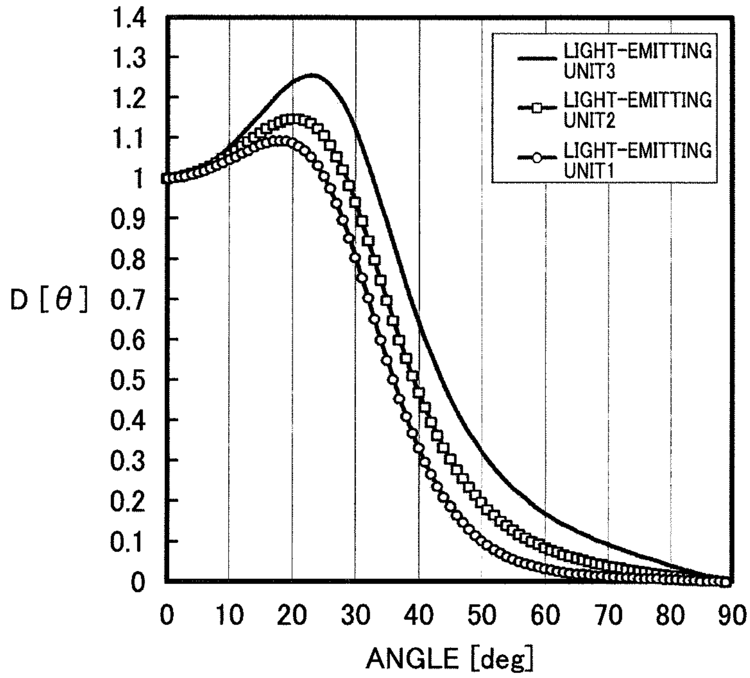
1.4
1.3
1.2
1.1
1
0.9
0.8
D [θ]
0.7
0.6
0.5
0.4
0.3
0.2
0.1
0
0 10 20 30 40 50 60 70 80 90
ANGLE [deg]
LIGHT-EMITTING UNIT3
LIGHT-EMITTING UNIT2
LIGHT-EMITTING UNIT1

FIG.21

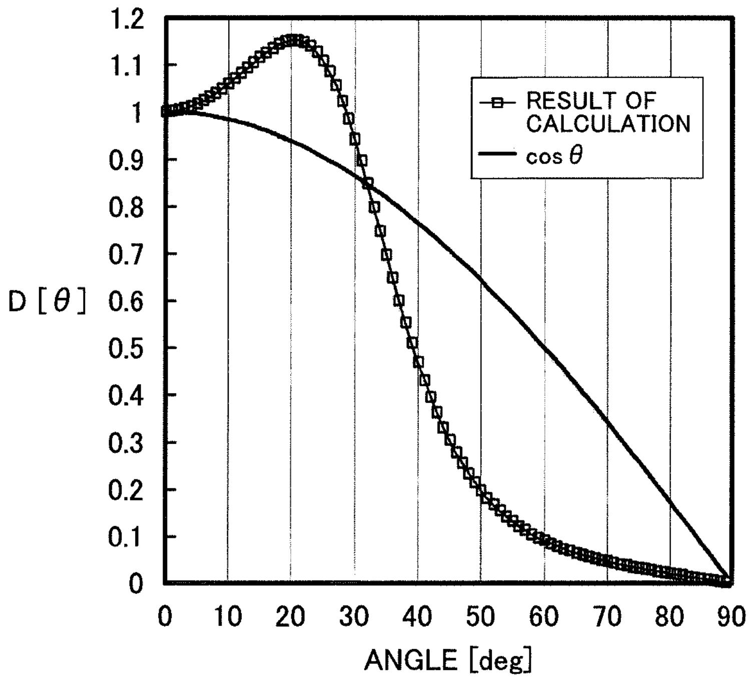
1.2
1.1
1
0.9
0.8
0.7
D [θ]
0.6
0.5
0.4
0.3
0.2
0.1
0
0 10 20 30 40 50 60 70 80 90
ANGLE [deg]
RESULT OF CALCULATION
cos θ

# FIG.22

DESIGN1

| | |
|---|---|
| THE NUMBER OF LIGHT-EMITTING UNITS nunit | 3 |
| WAVELENGTH [nm] | 625 |
| EFFECTIVE INDEX OF REFRACTION OF LIGHT-EMITTING FUNCTION LAYER | 1.74 |

| DESIGN OF PEAK ANGLE [deg] | | |
|---|---|---|
| $\theta 1$ [deg] | $\theta 2$ [deg] | $\theta 3$ [deg] |
| 15 | 10 | 5 |
| CALCULATION OF PEAK ANGLE [deg] | | |
| $\theta 1$ [deg] | $\theta 2$ [deg] | $\theta 3$ [deg] |
| 14 | 11 | 7 |
| CONDITION EXPRESSION | $\theta 1 > \theta 2 > \theta 3$ | |

| PARAMETER FOR THICKNESS L | | | |
|---|---|---|---|
| ORDER l | $L_{min}$ [nm] | $L_{max}$ [nm] | DESIGN OF L [nm] |
| $n_{unit}-1=2$ | 472 | 509 | 491 |

| POSITION OF EMISSION POINT d (LIGHT-EMITTING UNIT 1) | | | |
|---|---|---|---|
| ORDER m | $d_{min}$ [nm] | $d_{max}$ [nm] | DESIGN OF d [nm] |
| $n_{unit}-1=2$ | 420 | 456 | 456 |

| POSITION OF EMISSION POINT d (LIGHT-EMITTING UNIT 2) | | | |
|---|---|---|---|
| ORDER m | $d_{min}$ [nm] | $d_{max}$ [nm] | DESIGN OF d [nm] |
| $n_{unit}-2=1$ | 237 | 273 | 270 |

| POSITION OF EMISSION POINT d (LIGHT-EMITTING UNIT 3) | | | |
|---|---|---|---|
| ORDER m | $d_{min}$ [nm] | $d_{max}$ [nm] | DESIGN OF d [nm] |
| $n_{unit}-3=0$ | 56 | 92 | 56 |

# FIG.23

DESIGN 2

| | |
|---|---|
| THE NUMBER OF LIGHT-EMITTING UNITS nunit | 3 |
| WAVELENGTH [nm] | 625 |
| EFFECTIVE INDEX OF REFRACTION OF LIGHT-EMITTING FUNCTION LAYER | 1.74 |

| DESIGN OF PEAK ANGLE [deg] | | |
|---|---|---|
| $\theta 1$ [deg] | $\theta 2$ [deg] | $\theta 3$ [deg] |
| 15 | 20 | 25 |
| CALCULATION OF PEAK ANGLE [deg] | | |
| $\theta 1$ [deg] | $\theta 2$ [deg] | $\theta 3$ [deg] |
| 18 | 20 | 23 |
| CONDITION EXPRESSION | $\theta 1 < \theta 2 < \theta 3$ | |

| PARAMETER FOR THICKNESS L | | | |
|---|---|---|---|
| ORDER l | $L_{min}$ [nm] | $L_{max}$ [nm] | DESIGN OF L [nm] |
| $n_{unit}-1=2$ | 488 | 525 | 502 |

| POSITION OF EMISSION POINT d (LIGHT-EMITTING UNIT 1) | | | |
|---|---|---|---|
| ORDER m | $d_{min}$ [nm] | $d_{max}$ [nm] | DESIGN OF d [nm] |
| $n_{unit}-1=2$ | 420 | 457 | 420 |

| POSITION OF EMISSION POINT d (LIGHT-EMITTING UNIT 2) | | | |
|---|---|---|---|
| ORDER m | $d_{min}$ [nm] | $d_{max}$ [nm] | DESIGN OF d [nm] |
| $n_{unit}-2=1$ | 241 | 278 | 270 |

| POSITION OF EMISSION POINT d (LIGHT-EMITTING UNIT 3) | | | |
|---|---|---|---|
| ORDER m | $d_{min}$ [nm] | $d_{max}$ [nm] | DESIGN OF d [nm] |
| $n_{unit}-3=0$ | 58 | 96 | 96 |

# FIG.24

DESIGN 3

| | |
|---|---|
| THE NUMBER OF LIGHT-EMITTING UNITS nunit | 4 |
| WAVELENGTH [nm] | 625 |
| EFFECTIVE INDEX OF REFRACTION OF LIGHT-EMITTING FUNCTION LAYER | 1.74 |

| DESIGN OF PEAK ANGLE [deg] | | | |
|---|---|---|---|
| $\theta 1$ [deg] | $\theta 2$ [deg] | $\theta 3$ [deg] | $\theta 4$ [deg] |
| 12 | 14 | 16 | 18 |
| CALCULATION OF PEAK ANGLE [deg] | | | |
| $\theta 1$ [deg] | $\theta 2$ [deg] | $\theta 3$ [deg] | $\theta 4$ [deg] |
| 13 | 15 | 16 | 17 |
| CONDITION EXPRESSION | $\theta 1 < \theta 2 < \theta 3 < \theta 4$ | | |

| PARAMETER FOR THICKNESS L | | | |
|---|---|---|---|
| ORDER l | $L_{min}$ [nm] | $L_{max}$ [nm] | DESIGN OF L [nm] |
| $n_{unit}-1=3$ | 663 | 700 | 679 |

| POSITION OF EMISSION POINT d (LIGHT-EMITTING UNIT 1) | | | |
|---|---|---|---|
| ORDER m | $d_{min}$ [nm] | $d_{max}$ [nm] | DESIGN OF d [nm] |
| $n_{unit}-1=3$ | 600 | 636 | 600 |

| POSITION OF EMISSION POINT d (LIGHT-EMITTING UNIT 2) | | | |
|---|---|---|---|
| ORDER m | $d_{min}$ [nm] | $d_{max}$ [nm] | DESIGN OF d [nm] |
| $n_{unit}-2=2$ | 420 | 456 | 424 |

| POSITION OF EMISSION POINT d (LIGHT-EMITTING UNIT 3) | | | |
|---|---|---|---|
| ORDER m | $d_{min}$ [nm] | $d_{max}$ [nm] | DESIGN OF d [nm] |
| $n_{unit}-3=1$ | 239 | 276 | 250 |

| POSITION OF EMISSION POINT d (LIGHT-EMITTING UNIT 4) | | | |
|---|---|---|---|
| ORDER m | $d_{min}$ [nm] | $d_{max}$ [nm] | DESIGN OF d [nm] |
| $n_{unit}-3=0$ | 58 | 94 | 94 |

# FIG.25

DESIGN 4

| | |
|---|---|
| THE NUMBER OF LIGHT-EMITTING UNITS nunit | 3 |
| WAVELENGTH [nm] | 625 |
| EFFECTIVE INDEX OF REFRACTION OF LIGHT-EMITTING FUNCTION LAYER | 1.74 |

| CALCULATION OF PEAK ANGLE [deg] | | |
|---|---|---|
| θ1 [deg] | θ2 [deg] | θ3 [deg] |
| 0 | 69 | 64 |
| CONDITION EXPRESSION | $\theta 1 < \theta 3 < \theta 2$ | |

| | | |
|---|---|---|
| THICKNESS OF LIGHT-EMITTING FUNCTION LAYER | L [nm] | 405 |
| POSITION OF EMISSION POINT | d1 [nm] | 105 |
| | d2 [nm] | 150 |
| | d3 [nm] | 270 |

# FIG.26

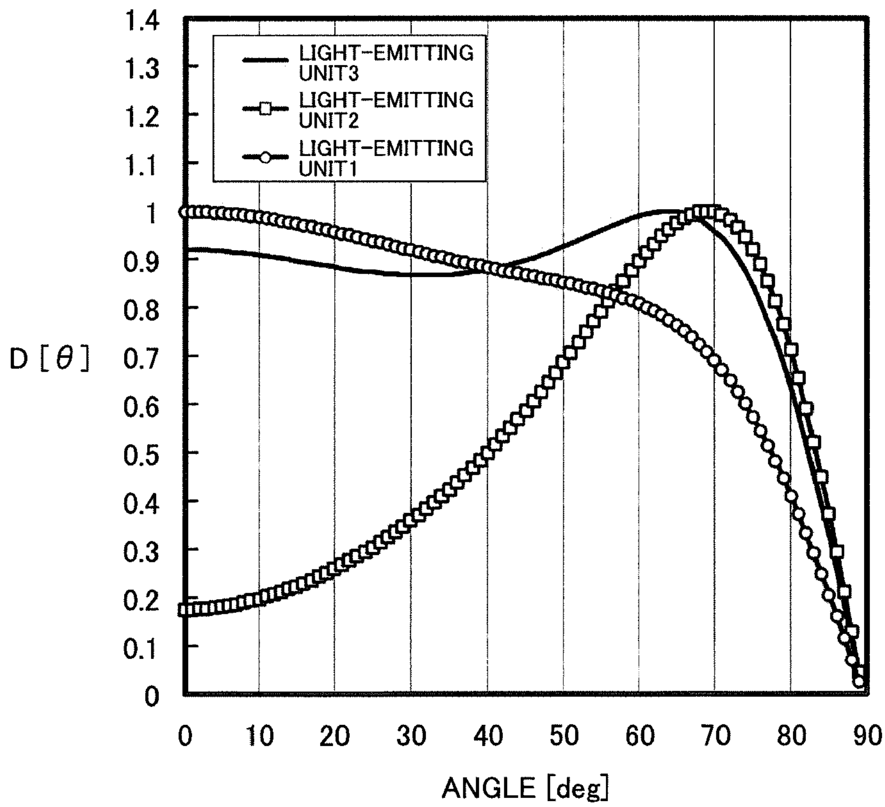

FIG.27

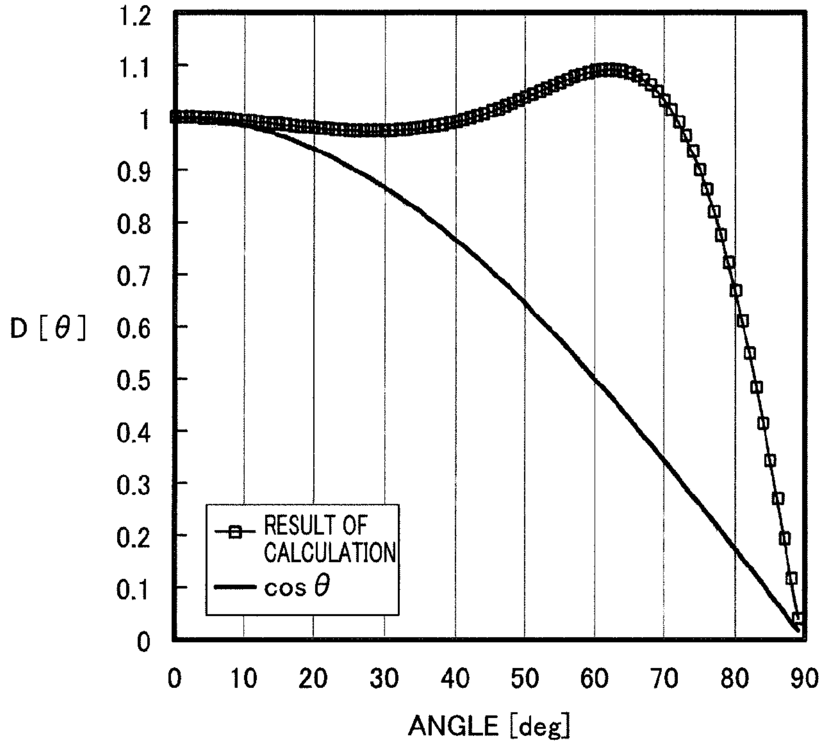
1.2
1.1
1
0.9
0.8
0.7
D [θ]
0.6
0.5
0.4
0.3
0.2
0.1
0
RESULT OF CALCULATION
cos θ
0 10 20 30 40 50 60 70 80 90
ANGLE [deg]

FIG.28

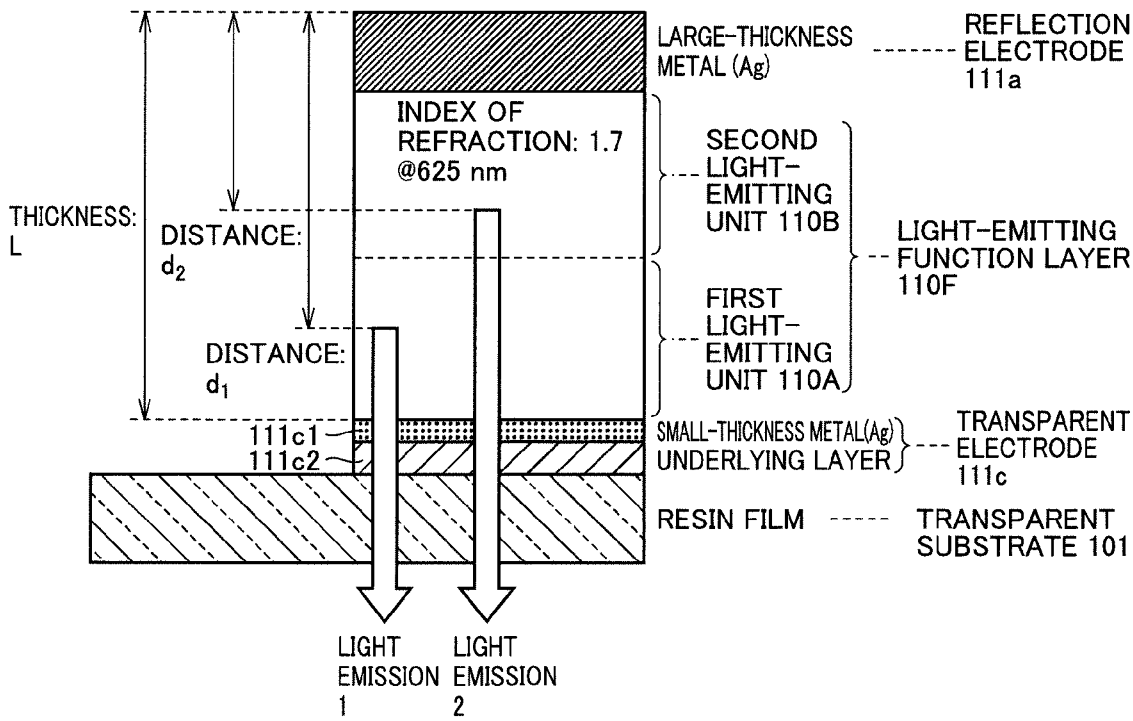
LARGE-THICKNESS METAL (Ag)
REFLECTION ELECTRODE 111a
INDEX OF REFRACTION: 1.7 @625 nm
SECOND LIGHT-EMITTING UNIT 110B
LIGHT-EMITTING FUNCTION LAYER 110F
FIRST LIGHT-EMITTING UNIT 110A
THICKNESS: L
DISTANCE: d2
DISTANCE: d1
111c1
111c2
SMALL-THICKNESS METAL(Ag)
UNDERLYING LAYER
TRANSPARENT ELECTRODE 111c
RESIN FILM
TRANSPARENT SUBSTRATE 101
LIGHT EMISSION 1
LIGHT EMISSION 2

# FIG.29

DESIGN 5

| | |
|---|---|
| THE NUMBER OF LIGHT-EMITTING UNITS nunit | 2 |
| WAVELENGTH [nm] | 625 |
| EFFECTIVE INDEX OF REFRACTION OF LIGHT-EMITTING FUNCTION LAYER | 1.74 |

| DESIGN OF PEAK ANGLE [deg] | |
|---|---|
| $\theta$1 [deg] | $\theta$2 [deg] |
| 10 | 20 |
| CALCULATION OF PEAK ANGLE [deg] | |
| $\theta$1 [deg] | $\theta$2 [deg] |
| 13 | 21 |
| CONDITION EXPRESSION | $\theta 1 < \theta 2$ |

| PARAMETER FOR THICKNESS L | | | |
|---|---|---|---|
| ORDER l | $L_{min}$ [nm] | $L_{max}$ [nm] | DESIGN OF L [nm] |
| $n_{unit}-1=2$ | 302 | 339 | 316 |

| POSITION OF EMISSION POINT d (LIGHT-EMITTING UNIT 1) | | | |
|---|---|---|---|
| ORDER m | $d_{min}$ [nm] | $d_{max}$ [nm] | DESIGN OF d [nm] |
| $n_{unit}-1=1$ | 241 | 277 | 241 |

| POSITION OF EMISSION POINT d (LIGHT-EMITTING UNIT 2) | | | |
|---|---|---|---|
| ORDER m | $d_{min}$ [nm] | $d_{max}$ [nm] | DESIGN OF d [nm] |
| $n_{unit}-2=0$ | 58 | 96 | 96 |

FIG.30

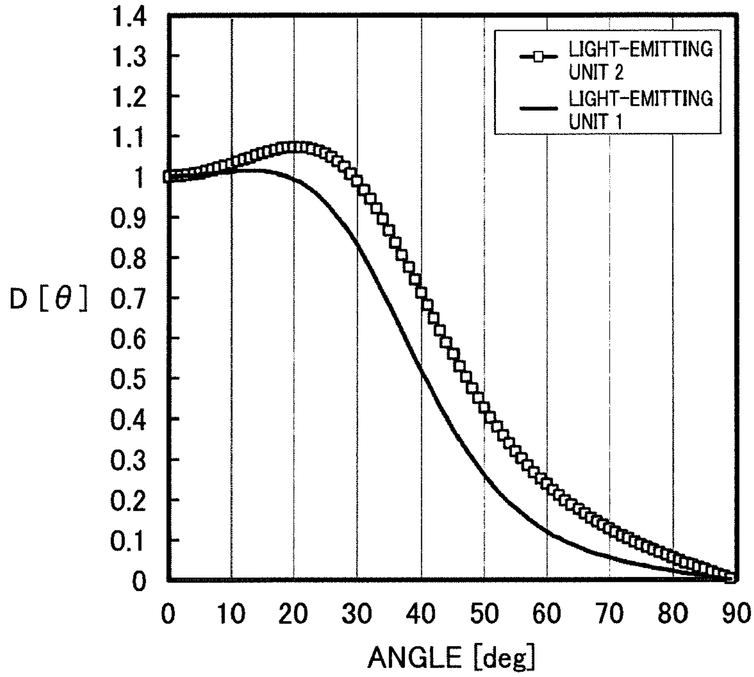
1.4
1.3
1.2
1.1
1
0.9
0.8
D [θ]
0.7
0.6
0.5
0.4
0.3
0.2
0.1
0
0
10
20
30
40
50
60
70
80
90
ANGLE [deg]
LIGHT-EMITTING UNIT 2
LIGHT-EMITTING UNIT 1

FIG.31

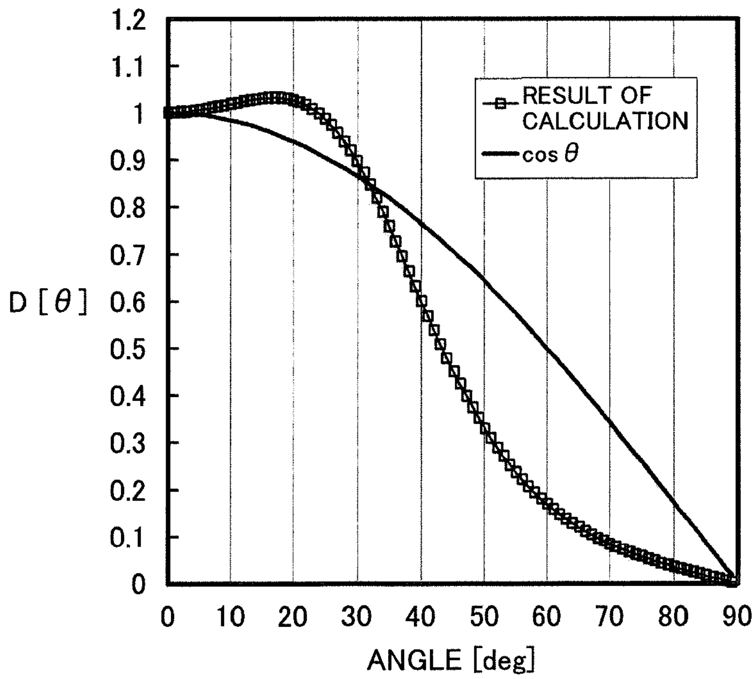
1.2
1.1
1
0.9
0.8
0.7
D [θ]
0.6
0.5
0.4
0.3
0.2
0.1
0
0
10
20
30
40
50
60
70
80
90
ANGLE [deg]
RESULT OF CALCULATION
cos θ

# FIG.32

DESIGN 6

| | |
|---|---|
| THE NUMBER OF LIGHT-EMITTING UNITS nunit | 2 |
| WAVELENGTH [nm] | 625 |
| EFFECTIVE INDEX OF REFRACTION OF LIGHT-EMITTING FUNCTION LAYER | 1.74 |

| DESIGN OF PEAK ANGLE [deg] | |
|---|---|
| $\theta$ 1 [deg] | $\theta$ 2 [deg] |
| 20 | 10 |
| CALCULATION OF PEAK ANGLE [deg] | |
| $\theta$ 1 [deg] | $\theta$ 2 [deg] |
| 21 | 14 |
| CONDITION EXPRESSION | $\theta 1 > \theta 2$ |

| PARAMETER FOR THICKNESS L | | | |
|---|---|---|---|
| ORDER l | $L_{min}$ [nm] | $L_{max}$ [nm] | DESIGN OF L [nm] |
| $n_{unit}-1=2$ | 303 | 340 | 314 |

| POSITION OF EMISSION POINT d (LIGHT-EMITTING UNIT 1) | | | |
|---|---|---|---|
| ORDER m | $d_{min}$ [nm] | $d_{max}$ [nm] | DESIGN OF d [nm] |
| $n_{unit}-1=1$ | 244 | 281 | 281 |

| POSITION OF EMISSION POINT d (LIGHT-EMITTING UNIT 2) | | | |
|---|---|---|---|
| ORDER m | $d_{min}$ [nm] | $d_{max}$ [nm] | DESIGN OF d [nm] |
| $n_{unit}-2=0$ | 58 | 94 | 58 |

FIG.33

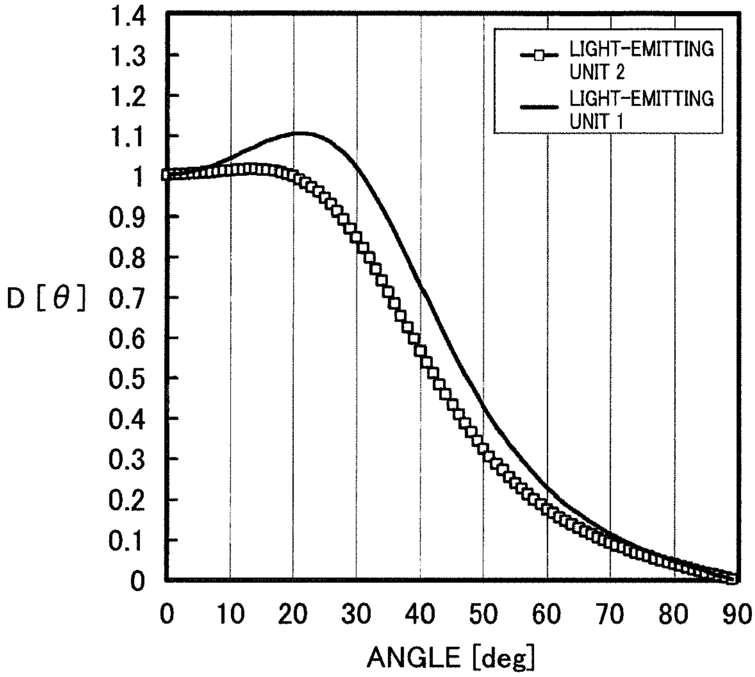
1.4
1.3
1.2
1.1
1
0.9
0.8
D [θ]
0.7
0.6
0.5
0.4
0.3
0.2
0.1
0
LIGHT-EMITTING UNIT 2
LIGHT-EMITTING UNIT 1
0
10
20
30
40
50
60
70
80
90
ANGLE [deg]

FIG.34

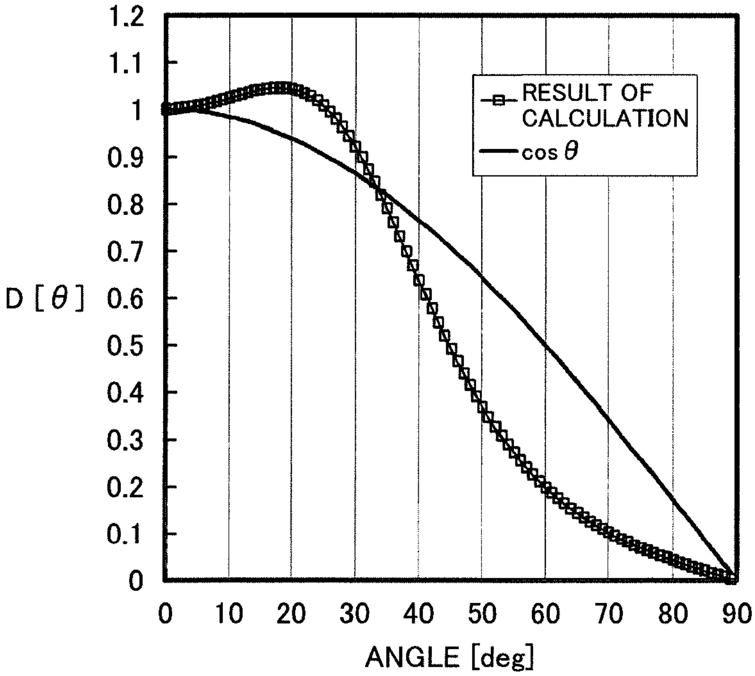
1.2
1.1
1
0.9
0.8
0.7
D [θ]
0.6
0.5
0.4
0.3
0.2
0.1
0
RESULT OF CALCULATION
cos θ
0
10
20
30
40
50
60
70
80
90
ANGLE [deg]

FIG.35

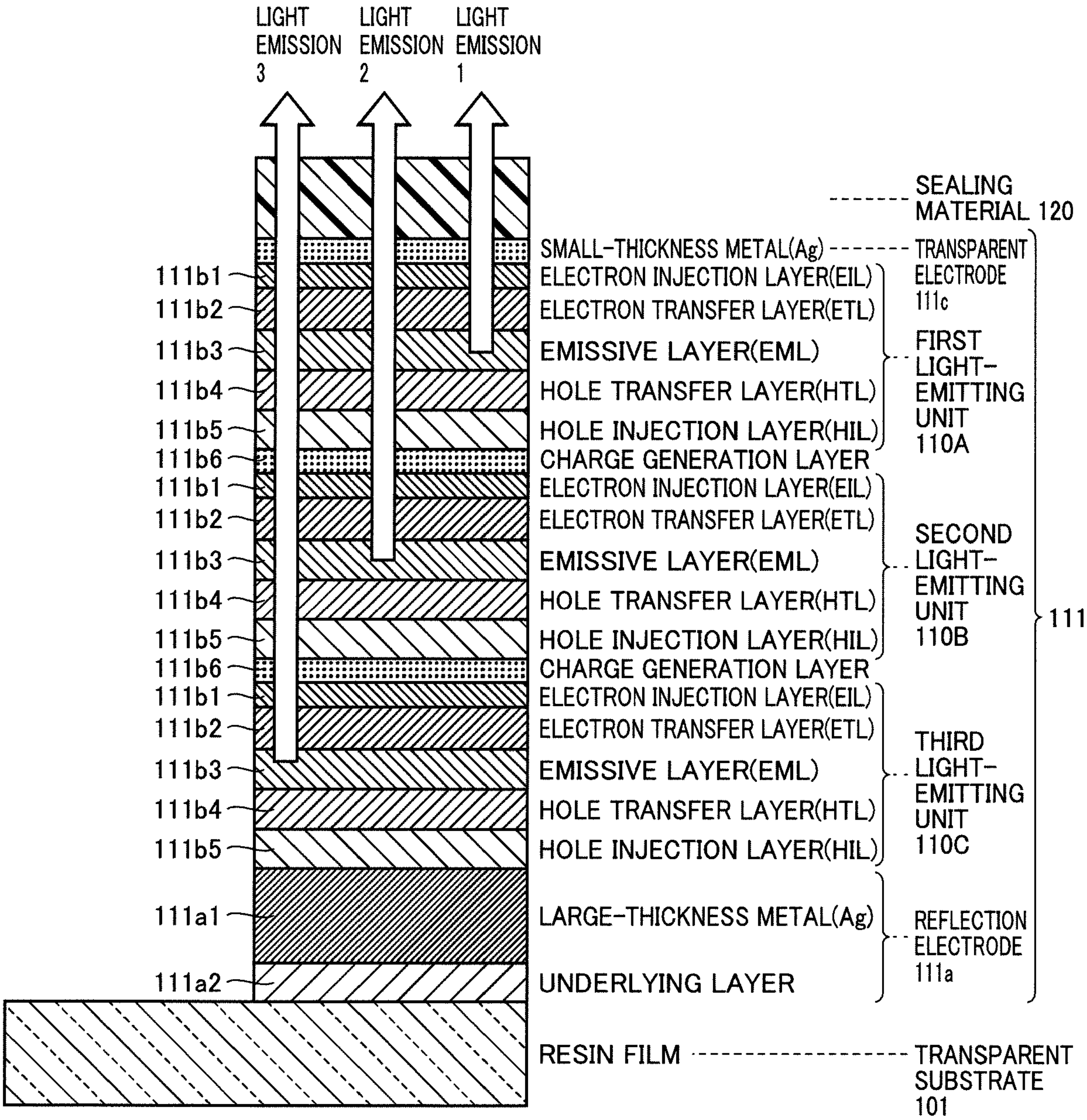
LIGHT EMISSION 3
LIGHT EMISSION 2
LIGHT EMISSION 1
SEALING MATERIAL 120
SMALL-THICKNESS METAL(Ag)
TRANSPARENT ELECTRODE 111c
111b1
ELECTRON INJECTION LAYER(EIL)
111b2
ELECTRON TRANSFER LAYER(ETL)
111b3
EMISSIVE LAYER(EML)
111b4
HOLE TRANSFER LAYER(HTL)
111b5
HOLE INJECTION LAYER(HIL)
FIRST LIGHT-EMITTING UNIT 110A
111b6
CHARGE GENERATION LAYER
111b1
ELECTRON INJECTION LAYER(EIL)
111b2
ELECTRON TRANSFER LAYER(ETL)
111b3
EMISSIVE LAYER(EML)
111b4
HOLE TRANSFER LAYER(HTL)
111b5
HOLE INJECTION LAYER(HIL)
SECOND LIGHT-EMITTING UNIT 110B
111b6
CHARGE GENERATION LAYER
111b1
ELECTRON INJECTION LAYER(EIL)
111b2
ELECTRON TRANSFER LAYER(ETL)
111b3
EMISSIVE LAYER(EML)
111b4
HOLE TRANSFER LAYER(HTL)
111b5
HOLE INJECTION LAYER(HIL)
THIRD LIGHT-EMITTING UNIT 110C
111
111a1
LARGE-THICKNESS METAL(Ag)
111a2
UNDERLYING LAYER
REFLECTION ELECTRODE 111a
RESIN FILM
TRANSPARENT SUBSTRATE 101

FIG.36

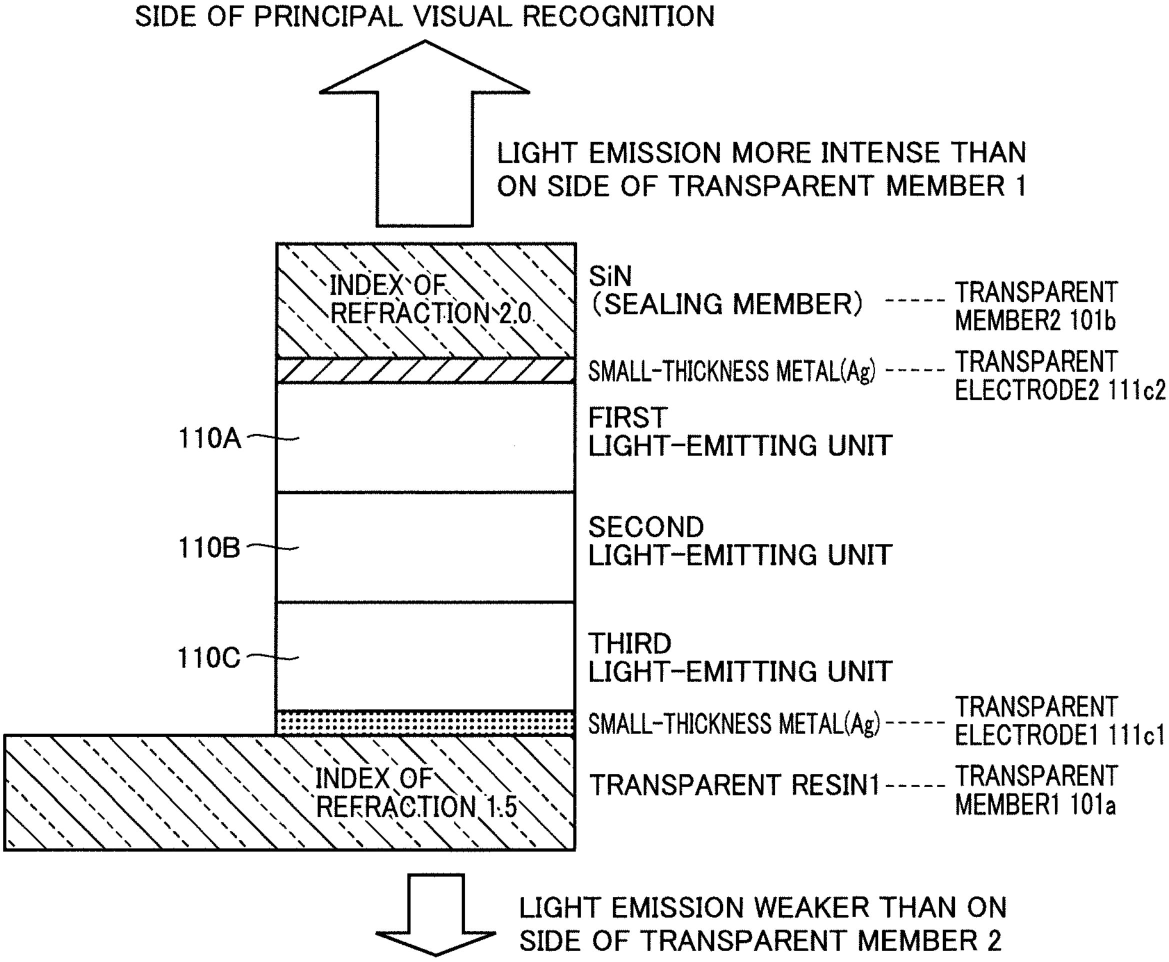
SIDE OF PRINCIPAL VISUAL RECOGNITION
LIGHT EMISSION MORE INTENSE THAN ON SIDE OF TRANSPARENT MEMBER 1
INDEX OF REFRACTION 2.0
SiN (SEALING MEMBER)
TRANSPARENT MEMBER2 101b
SMALL-THICKNESS METAL(Ag)
TRANSPARENT ELECTRODE2 111c2
110A
FIRST LIGHT-EMITTING UNIT
110B
SECOND LIGHT-EMITTING UNIT
110C
THIRD LIGHT-EMITTING UNIT
SMALL-THICKNESS METAL(Ag)
TRANSPARENT ELECTRODE1 111c1
INDEX OF REFRACTION 1.5
TRANSPARENT RESIN1
TRANSPARENT MEMBER1 101a
LIGHT EMISSION WEAKER THAN ON SIDE OF TRANSPARENT MEMBER 2

FIG.37

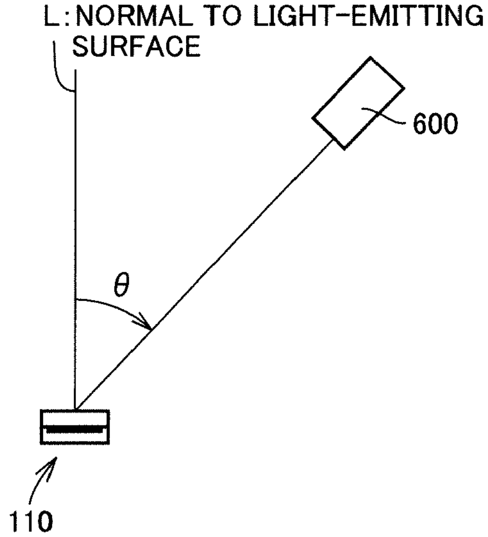
L: NORMAL TO LIGHT-EMITTING SURFACE
600
θ
110

FIG.38

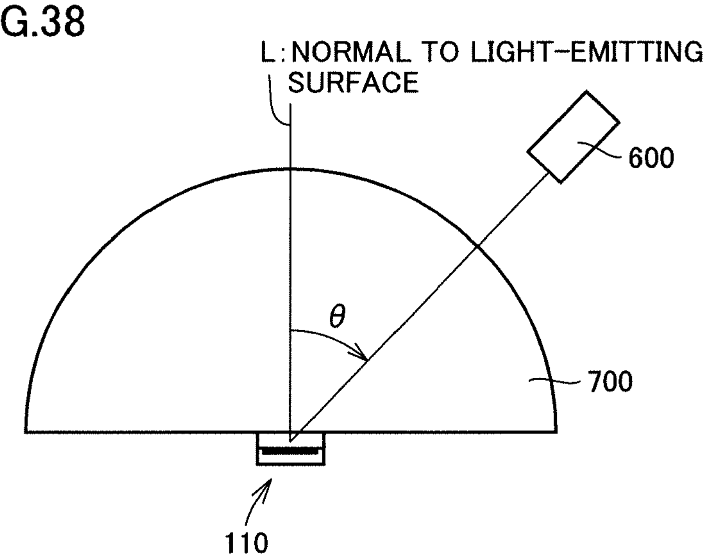
L: NORMAL TO LIGHT-EMITTING SURFACE
600
θ
700
110

Europäisches Patentamt
European Patent Office
Office européen des brevets

# EUROPEAN SEARCH REPORT

Application Number
EP 16 17 2135

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 2010/314636 A1 (FUKUDA T; JIRO Y; MATSUNAMI N; MATSUNAMI S; NARIYUKI M; SHIGEYUKI M; S) 16 December 2010 (2010-12-16) * claim 1 * * the whole document * ----- | 1-6 | INV. H05B33/12 H01L51/00 H01L51/50 H01L27/28 |
| X,D | JP 2014 225415 A (PANASONIC CORP) 4 December 2014 (2014-12-04) * claim 1 * * the whole document * ----- | 1-6 | |
| X | EP 1 737 276 A1 (IDEMITSU KOSAN CO [JP]) 27 December 2006 (2006-12-27) * claim 1 * * the whole document * ----- | 1-6 | |
| A | US 2013/082246 A1 (HASEGAWA TOSHINORI [JP]) 4 April 2013 (2013-04-04) * claim 1 * * the whole document * ----- | 1-6 | TECHNICAL FIELDS SEARCHED (IPC) |
| A | US 2013/119357 A1 (KIM HWA-KYUNG [KR] ET AL) 16 May 2013 (2013-05-16) * claim 1 * * the whole document * ----- | 1-6 | H05B H01L |

The present search report has been drawn up for all claims

1

| Place of search | Date of completion of the search | Examiner |
|---|---|---|
| The Hague | 2 December 2016 | Ziegler, Jan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 16 17 2135

This annex lists the patent family members relating to the patent documents cited in the above-mentioned European search report. The members are as contained in the European Patent Office EDP file on
The European Patent Office is in no way liable for these particulars which are merely given for the purpose of information.

02-12-2016

| Patent document cited in search report | Publication date | Patent family member(s) | Publication date |
|---|---|---|---|
| US 2010314636 A1 | 16-12-2010 | CN 101924123 A | 22-12-2010 |
| | | JP 2010287484 A | 24-12-2010 |
| | | KR 20100133890 A | 22-12-2010 |
| | | TW 201106779 A | 16-02-2011 |
| | | US 2010314636 A1 | 16-12-2010 |
| JP 2014225415 A | 04-12-2014 | NONE | |
| EP 1737276 A1 | 27-12-2006 | CN 1939096 A | 28-03-2007 |
| | | EP 1737276 A1 | 27-12-2006 |
| | | JP 2005302313 A | 27-10-2005 |
| | | TW 200539746 A | 01-12-2005 |
| | | US 2008272690 A1 | 06-11-2008 |
| | | WO 2005104624 A1 | 03-11-2005 |
| US 2013082246 A1 | 04-04-2013 | CN 103077954 A | 01-05-2013 |
| | | JP 2013077383 A | 25-04-2013 |
| | | US 2013082246 A1 | 04-04-2013 |
| US 2013119357 A1 | 16-05-2013 | CN 103107288 A | 15-05-2013 |
| | | US 2013119357 A1 | 16-05-2013 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2015112557 A
- JP 2010287484 A
- JP 2014225415 A
- JP 5266532 B
- JP 2014182997 A

### Non-patent literature cited in the description

- **KOTARO KAJIKAWA et al.** Active Plasmonics. Corona Publishing Co., Ltd, 2013